# EUROPEAN PATENT APPLICATION

(11) **EP 4 773 766 A1**
(43) Date of publication of application: **08.07.2026**
(21) Application number: 23961067.8
(22) Date of filing: 12.12.2023
(51) Int. Cl.: H10K 50/822, H10K 50/824

(54) **DISPLAY PANEL AND DISPLAY APPARATUS**

(71) Applicant: Boe Technology Group Co., Ltd., Beijing 100015 (CN); Yunnan Invensight Optoelectronics Technology Co., Ltd., Kunming, Yunnan 650211 (CN)
(72) Inventor: WEI, Junbo, Beijing 100176 (CN); SHAN, Qingshan, Beijing 100176 (CN); LU, Pengcheng, Beijing 100176 (CN); HUANG, Yinhu, Beijing 100176 (CN); YANG, Shengji, Beijing 100176 (CN); TIAN, Yuanlan, Beijing 100176 (CN); ZHANG, Dacheng, Beijing 100176 (CN)
(74) Representative: Isarpatent
(86) International application number: PCT/CN2023/138041
(87) International publication number: WO 2025/123201

(57) **Abstract**

The present disclosure provides a display panel and a display device, relating to the technical field of displaying. The display panel includes a substrate and a plurality of light emitting devices arranged in an array on the substrate, the light emitting devices being located at least in the active area ; the display panel further includes a first conductive layer, including a first cathode ring and of the plurality of light emitting devices; the first cathode ring is located in the peripheral area and the first cathode ring surrounds the active area and the first cathode ring is electrically connected to a pixel circuit of the display panel; the first cathode ring includes a plurality of conductive patterns, a gap is provided between two adjacent conductive patterns, and a plane figure of each conductive pattern includes a concave polygon. The display panel is suitable for preparation of high-quality display devices.

## Description

### TECHNICAL FIELD

The present disclosure relates to the technical field of displaying, and particularly relates to a display panel and a display device.

### BACKGROUND

With the rapid development of various display technologies, customers have increasingly high requirements for the performance of display panels. Currently, silicon-based display products are provided with cathodes of light emitting devices located in an active area (AA) and a cathode ring located in the peripheral area. Among them, the cathode ring is arranged around the active area.

However, the current design of the cathode ring is prone to causing electrostatic discharge (ESD) in the peripheral area of the display products, which may cause corrosion or burns in the peripheral area of the display products and damage them.

### SUMMARY

The present disclosure employs the following technical solutions:
In a first aspect, the present disclosure provides a display panel, including an active area and a peripheral area, the peripheral area surrounding the active area; and the display panel further includes:
a substrate and a plurality of light emitting devices arranged in an array on the substrate, the plurality of light emitting devices being located at least in the active area;
a first conductive layer, including a first cathode ring and anodes of the plurality of light emitting devices, wherein the first cathode ring is located in the peripheral area and the first cathode ring surrounds the active area, and the first cathode ring is electrically connected to a pixel circuit of the display panel; and
the first cathode ring includes a plurality of conductive patterns, a gap is provided between two adjacent conductive patterns, and a plane figure of each of the conductive patterns includes a concave polygon.

In at least one display panel provided by an embodiment of the present disclosure, a shape of an orthographic projection of each of the conductive patterns on the substrate includes a figure formed by splicing a first extension part and a second extension part together; and
the first extension part extends along a first direction, the second extension part extends along a second direction, the first direction is a direction pointing from the active area to the peripheral area, and the second direction is perpendicular to the first direction.

In at least one display panel provided by an embodiment of the present disclosure, a plane figure of the first extension part is a first rectangle, and a plane figure of the second extension part is a second rectangle; and
a geometric center of the first rectangle overlaps with a geometric center of the second rectangle, a first side of the first rectangle is perpendicular to a first side of the second rectangle, and the first side is a long side of a rectangle.

In at least one display panel provided by an embodiment of the present disclosure, the plurality of conductive patterns include a first conductive pattern group and a second conductive pattern group that are alternately arranged along the first direction, and the first conductive pattern group and the second conductive pattern group are both arranged around the active area;
the first conductive pattern group includes a plurality of first conductive patterns arranged along the second direction, and the second conductive pattern group includes a plurality of second conductive pattern arranged along the second direction; and
a shape of a line connecting geometric centers of two first conductive patterns adjacent along the first direction and a geometric center of a second conductive pattern between the two first conductive patterns adjacent along the first direction is a first triangle.

In at least one display panel provided by an embodiment of the present disclosure, structures and sizes of the first conductive patterns are the same as that of the second conductive patterns.

In at least one display panel provided by an embodiment of the present disclosure, at least one side length of the first triangle is 3~5 times a maximum size of sub-pixels in the active area.

In at least one display panel provided by an embodiment of the present disclosure, the first triangle is an isosceles triangle.

In at least one display panel provided by an embodiment of the present disclosure, the first side of the first rectangle extends along the first direction, the first side of the second rectangle extends along the second direction, and an area of the first rectangle is greater than an area of the second rectangle.

In at least one display panel provided by an embodiment of the present disclosure, along the first direction, a minimum distance between the second conductive pattern and the first conductive pattern that is on a side close to the active area is a first distance, a minimum distance between the second conductive pattern and the first conductive pattern that is on a side away from the active area is a second distance, and the first distance and the second distance are roughly equal.

In at least one display panel provided by an embodiment of the present disclosure, along the second direction, a minimum distance between the second conductive pattern and the first conductive pattern on one side of the second conductive pattern is a third distance, a minimum distance between the second conductive pattern and the first conductive pattern on another side of the second conductive pattern is a fourth distance, and the third distance and the fourth distance are roughly equal.

In at least one display panel provided by an embodiment of the present disclosure, ranges of the first distance, the second distance, the third distance and the fourth distance are all 0.5~2 times a maximum size of sub-pixels in the active area.

In at least one display panel provided by an embodiment of the present disclosure, the first distance, the second distance, the third distance and the fourth distance are all roughly equal.

In at least one display panel provided by an embodiment of the present disclosure, a length of the first side of the first rectangle is less than or equal to a length of the first side of the second rectangle, and the length of the first side of the second rectangle is greater than 0.5 times the length of the first side of the first rectangle.

In at least one display panel provided by an embodiment of the present disclosure, a maximum width of the first extension part along the second direction is greater than a maximum width of the second extension part along the first direction.

In at least one display panel provided by an embodiment of the present disclosure, in the first rectangle and the second rectangle, the length of the first side is greater than a length of a second side; and
an absolute value of a difference between the length of the first side of the first rectangle and the length of the second side of the first rectangle is greater than or equal to 0.5~2 times a maximum size of sub-pixels in the active area.

In at least one display panel provided by an embodiment of the present disclosure, for the first conductive pattern and the second conductive pattern adjacent along the first direction, a minimum distance from the first side of the second rectangle in the first conductive pattern to the first side of the second rectangle in the second conductive pattern is a fifth distance; a minimum distance from the first side of the second rectangle in the second conductive pattern to the first side of the second rectangle in the first conductive pattern is the fifth distance; in the same conductive pattern, a minimum distance between the first side of the first rectangle and the second side of the second rectangle is a sixth distance; the fifth distance is greater than the sixth distance.

In at least one display panel provided by an embodiment of the present disclosure, for two first conductive patterns adjacent along the first direction, a minimum distance between the first sides of the second rectangles in the two first conductive patterns is a seventh distance; for two second conductive patterns adjacent along the first direction, a minimum distance between the first sides of the second rectangles in the two second conductive patterns is the seventh distance;

for two first conductive patterns adjacent along the second direction, a minimum distance between the first sides of the first rectangles in the two first conductive patterns is an eighth distance; for two second conductive patterns adjacent along the second direction, a minimum distance between the first sides of the first rectangles in the two second conductive pattern is the eighth distance;
where the seventh distance is greater than or equal to the eighth distance.

In at least one display panel provided by an embodiment of the present disclosure, a ratio of a length of the seventh distance to a length of the first side of the first rectangle, is greater than or equal to a ratio of a length of the eighth distance to a length of a second side of the first rectangle.

In at least one display panel provided by an embodiment of the present disclosure, a first hollow area is provided between two conductive patterns adjacent along the second direction;
a line connecting geometric centers of two first hollow areas adjacent along the first direction and a geometric center of a conductive pattern between the two first hollow areas adjacent along the first direction is a first line segment; and
a line connecting the geometric centers of the two first conductive patterns adjacent along the first direction is a second line segment; the first line segment is parallel to the second line segment.

In at least one display panel provided by an embodiment of the present disclosure, a length of the first line segment and a length of the second line segment are roughly equal.

In at least one display panel provided by an embodiment of the present disclosure, two first hollow areas arranged along the first direction and located on two sides of the first rectangle, and two first hollow area arranged along the second direction and located on two sides of the second rectangle are disposed around the same conductive pattern;
a shape formed by a line connecting geometric centers of four first hollow areas around the same conductive pattern in sequence is a quadrilateral, the quadrilateral includes two second triangles, and the two second triangles are the same as the first triangle.

In at least one display panel provided by an embodiment of the present disclosure, the display panel further includes a plurality of auxiliary electrodes, the plurality of auxiliary electrodes are disposed in the peripheral area, two adjacent auxiliary electrodes arranged along the first direction are not in contact with each other, the orthographic projections of the plurality of conductive patterns on the substrate overlap with orthographic projections of the plurality of auxiliary electrodes on the substrate, and the plurality of conductive patterns are electrically connected to the plurality of auxiliary electrodes.

In at least one display panel provided by an embodiment of the present disclosure, the plane figures of the plurality of conductive patterns are axisymmetric shapes, the plurality of conductive patterns have first axes of symmetry extending along the second direction; areas where the first axes of symmetry are located overlap with areas where the orthographic projections of the plurality of auxiliary electrodes on the substrate are located.

In at least one display panel provided by an embodiment of the present disclosure, the display panel further includes a pixel definition layer and a cathode layer located on one side of the pixel definition layer away from the substrate, a part of the pixel definition layer located in the peripheral area includes a plurality of first through-holes; the first cathode ring is disposed at bottoms of the plurality of first through-holes; and
a part area of the cathode layer falls into the plurality of first through-holes and is electrically connected to the plurality of conductive patterns through the plurality of first through-holes.

In at least one display panel provided by an embodiment of the present disclosure, the display panel further includes a driving baseplate, the driving baseplate includes the substrate and a driving unit, and the driving unit is located between the substrate and the first conductive layer; and
a part of the driving unit located in the peripheral area includes a second cathode ring, a part of the driving unit located in the active area includes a pixel circuit, the second cathode ring is electrically connected to the first cathode ring and the pixel circuit, respectively; an orthographic projection of the second cathode ring on the substrate is located within an orthographic projection of the first cathode ring on the substrate.

In at least one display panel provided by an embodiment of the present disclosure, a width of the second cathode ring along the first direction is less than a width of the first cathode ring along the first direction, and structures of the conductive patterns in the second cathode ring are the same as that of the conductive patterns in the first cathode ring.

In at least one display panel provided by an embodiment of the present disclosure, the plurality of auxiliary electrodes includes a plurality of first connecting electrodes and a plurality of second connecting electrodes, the driving baseplate includes a second conductive layer, and the second conductive layer is located between the plurality of second connecting electrodes and the substrate; and
the plurality of first connecting electrodes are located between the first cathode ring and the second cathode ring, and the plurality of first connecting electrodes contact and are electrically connected to the first cathode ring and the second cathode ring, respectively; the plurality of second connecting electrodes are located between the second conductive layer and the second cathode ring, the plurality of second connecting electrodes contact and are electrically connected to the second cathode ring and the second conductive layer, respectively, and the second conductive layer is electrically connected to the pixel circuit.

In at least one display panel provided by an embodiment of the present disclosure, for the plurality of auxiliary electrodes overlapping with the same conductive pattern in the first cathode ring, a quantity of a plurality of auxiliary electrodes overlapping with the first rectangle is greater than or equal to a quantity of a plurality of auxiliary electrodes overlapping with the second rectangle.

In at least one display panel provided by an embodiment of the present disclosure, for the conductive patterns in the second cathode ring, orthographic projections of the first connecting electrode and the second connecting electrode, that overlap with the same conductive pattern respectively, on the conductive pattern do not completely overlap.

In a second aspect, an embodiment of the present disclosure provides a display device, including the display panel according to any one of the first aspect.

The above description is merely a summary of the technical solutions of the present disclosure. In order to more clearly know the elements of the present disclosure to enable the implementation according to the contents of the description, and in order to make the above and other purposes, features and advantages of the present disclosure more apparent and understandable, the particular embodiments of the present disclosure are provided below.

### BRIEF DESCRIPTION OF THE DRAWINGS

In order to more clearly illustrate the technical solutions of the embodiments of the present disclosure or the related art, the figures that are required to describe the embodiments or the related art will be briefly described below. Apparently, the figures that are described below are embodiments of the present disclosure, and a person skilled in the art can obtain other figures according to these figures without paying creative work.
FIG. 1A and FIG. 1B are schematic diagrams of two top view structures of display panels according to embodiments of the present disclosure;
FIG. 2 is a schematic diagram of a cross-sectional structure along an A1A2 direction in FIG. 1A;
FIG. 3 is a schematic diagram of a cross-sectional structure along an A3A4 direction in FIG. 1A;
FIG. 4 is a schematic diagram of a partial top view structure of a first cathode ring according to an embodiment of the present disclosure;
FIG. 5A is a schematic diagram of a top view structure of a conductive pattern in a first cathode ring according to an embodiment of the present disclosure;
Plan (1) ~ plan (12) in FIG. 5B are schematic diagrams of top view structures of twelve types of conductive patterns in first cathode rings according to embodiments of the present disclosure;
FIG. 6 and FIG. 7 are schematic diagrams of partial top view structures of two types of first cathode rings according to embodiments of the present disclosure;
FIG. 8, FIG. 9 and FIG. 10 are top views illustrating arrangement relationships between the first cathode rings and the auxiliary electrodes according to embodiments of the present disclosure;
FIG. 11 to FIG. 13 are schematic diagrams of three types of position arrangements of conductive patterns in first cathode rings and first through-holes according to embodiments of the present disclosure;
FIG. 14 to FIG. 17 are schematic diagrams of four types of position arrangements of first connecting electrodes and second connecting electrodes on a conductive pattern of a second cathode ring according to embodiments of the present disclosure;
FIG. 18 and FIG. 19 are schematic diagrams of two types of simplified structures of display panels according to embodiments of the present disclosure; and
FIG. 20 is a schematic structural diagram of a display device according to an embodiment of the present disclosure.

### DETAILED DESCRIPTION

The technical solutions according to the embodiments of the present disclosure will be clearly and completely described below with reference to the drawings according to the embodiments of the present disclosure. Apparently, the described embodiments are merely certain embodiments of the present disclosure, rather than all of the embodiments. All of the other embodiments that a person skilled in the art obtains on the basis of the embodiments of the present disclosure without paying creative work fall within the protection scope of the present disclosure.

In the embodiments of the present disclosure, the use of words such as "first", "second", "third", "fourth" to distinguish similar or identical items with similar functions and effects is only for the purpose of clearly describing the technical solution of the embodiments of the present disclosure, and cannot be understood as indicating or implying relative importance or implying the number of technical features indicated.

In the embodiments of the present disclosure, the terms "up", "down", etc. indicate orientation or positional relationships based on the orientation or positional relationships shown in the accompanying drawings, only for the convenience of describing the present disclosure and simplifying the description, and do not indicate or imply that the device or component referred to must have a specific orientation, be constructed and operated in a specific orientation, and therefore cannot be understood as a limitation of the present disclosure.

In the description of the specification, the terms "one embodiment", "some embodiments", "exemplary embodiments", "examples", "specific examples" or "some examples" are intended to indicate that specific features, structures, materials or characteristics related to the embodiment or example are included in at least one embodiment or example of the present disclosure. The schematic representation of the above terms does not necessarily refer to the same embodiment or example. In addition, the specific features, structures, materials, or characteristics described may be included in any appropriate manner in any one or more embodiments or examples.

In the embodiments of the present disclosure, the meaning of "plurality of" refers to two or more, and the meaning of "at least one" refers to one or more, unless otherwise specified.

The features such as "parallel", "perpendicular", and "identical" used in the embodiments of this application include strictly defined features such as "parallel", "perpendicular", "identical", as well as situations where "roughly parallel", "roughly perpendicular", "roughly identical", etc. contain certain tolerances. Considering the tolerances related to measurement and measurement of specific quantities (such as limitations of measurement systems), they represent the acceptable deviation range for specific values determined by persons skilled in the art. For example, "roughly" can mean within one or more standard deviations, or within 10% or 5% of the value.

Unless otherwise required by the context, the term "including/comprising" shall be interpreted throughout the specification and claims as open and inclusive, meaning "including, but not limited to".

The term "same layer" in the embodiment of the present disclosure refers to the relationship between multiple film layers formed by the same material after undergoing the same step (such as a one-step patterning process). The term "same layer" here does not always refer to multiple film layers having the same thickness or having the same height in the cross-sectional view. The polygons in this specification are not strictly defined and can be approximate triangles, parallelograms, trapezoids, pentagons, hexagons, etc. There may be some small deformations caused by tolerances.

Micro Organic Light Emitting Diode (Micro OLED) display product is a new type of OLED display device with a silicon substrate as a back panel. Silicon-based OLED display products have the characteristics of small size and high resolution. The back panel is made using mature integrated circuit Complementary Metal Oxide Semiconductor (CMOS) technology, achieving active addressing of pixels, including various circuits such as Timer Control Register (TCON) and Over Current Protection (OCP), which can achieve lightweight.

Silicon-based OLED display products are widely used in the fields of near eye display, virtual reality (VR), and augmented reality (AR), especially in AR/VR head mounted display devices. With the rapid development of various display technologies, customers have increasingly high requirements for the performance of display panels. Currently, silicon-based display products are provided with cathodes of light emitting devices located in the active area (AA) and a cathode ring located in the peripheral area. Among them, the cathode ring is arranged around the active area. However, the current design of the cathode ring is prone to causing Electrostatic Discharge (ESD) in the peripheral area of the display products, which can cause corrosion or burns in the peripheral area of the display products and damage them.

Based on this, the embodiments of the present disclosure provide a display panel and a display device, among them, the display panel includes an active area and a peripheral area, the peripheral area surrounds the active area. The display panel further includes: a substrate, a plurality of light emitting devices arranged in an array on the substrate, and a first conductive layer; the plurality of light emitting devices are located at least in the active area; the first conductive layer includes a first cathode ring and an anode of each light emitting device that are electrically connected; the first cathode ring is located in the peripheral area and the first cathode ring surrounds the active area, and the first cathode ring is electrically connected to a pixel circuit of the display panel; among them, the first cathode ring includes a plurality of conductive patterns, and plane figures of the plurality of conductive patterns include a concave polygon. In the display panel provided by the embodiment of the present disclosure, the first cathode ring includes the plurality of conductive patterns, a gap is provided between two adjacent conductive patterns, and the plane figures of the plurality of conductive patterns include the concave polygon. In this way, compared to convex polygons, the concave polygons have more vertex angles (tip structures) with relatively smaller angles. By setting multiple tip structures, it is beneficial to guide the accumulated static electricity away from the conductive path, thereby releasing static electricity and greatly reducing the risk of ESD in the display panel, thereby improving the yield, quality, and reliability of the display panel.

The display panel and display device provided in the embodiments of the present disclosure will be specifically explained and introduced in conjunction with the accompanying drawings.

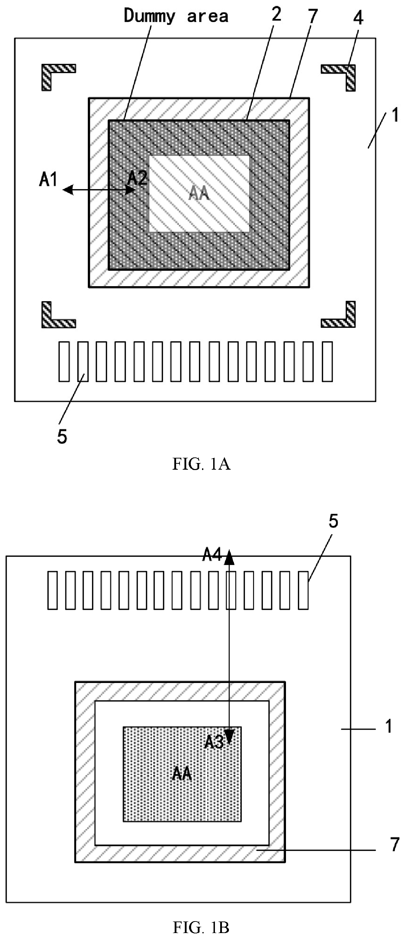

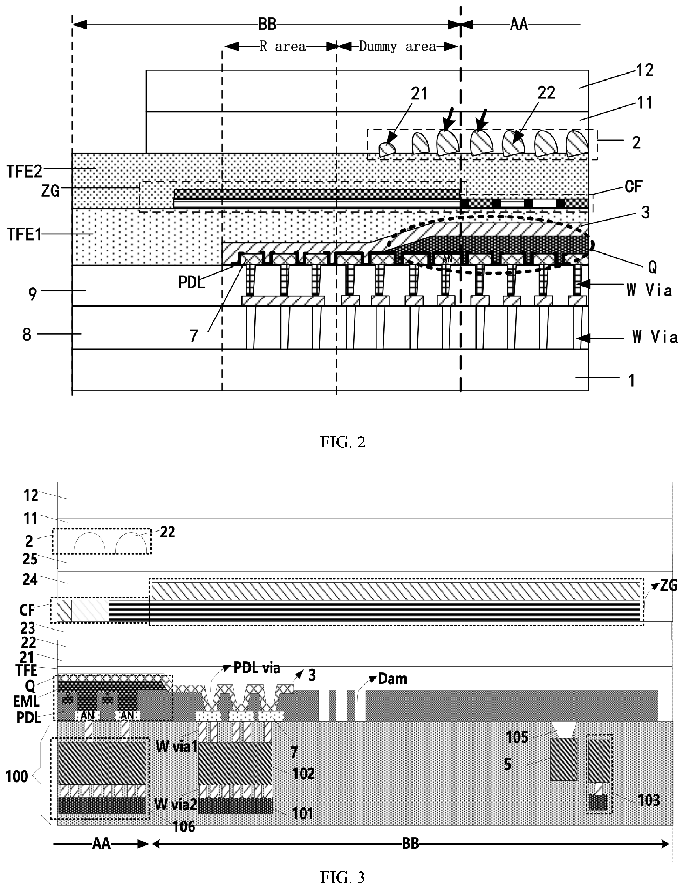

FIG. 1A and FIG. 1B shows schematic diagrams of two top view structures of the display panel, FIG. 2 and FIG. 3 shows schematic diagrams of two cross-sectional structures of the display panel. In FIG. 1A, a positional relationship between a lens layer 2 and the first cathode ring 7 is illustrated, but in FIG. 1B, the lens layer 2 is not depicted. In addition, FIG. 2 is a schematic diagram of a cross-sectional structure along an A1A2 direction in FIG. 1A, and FIG. 3 is a schematic diagram of a cross-sectional structure along an A3A4 direction in FIG. 1A. It should be noted that the cross-sectional structure of the area between the active area AA and the first cathode ring 7 is not shown in FIG. 3. In some display panels used in practical applications, a Dummy area (Dummy pixel area) can also be disposed between the active area AA and the first cathode ring 7.

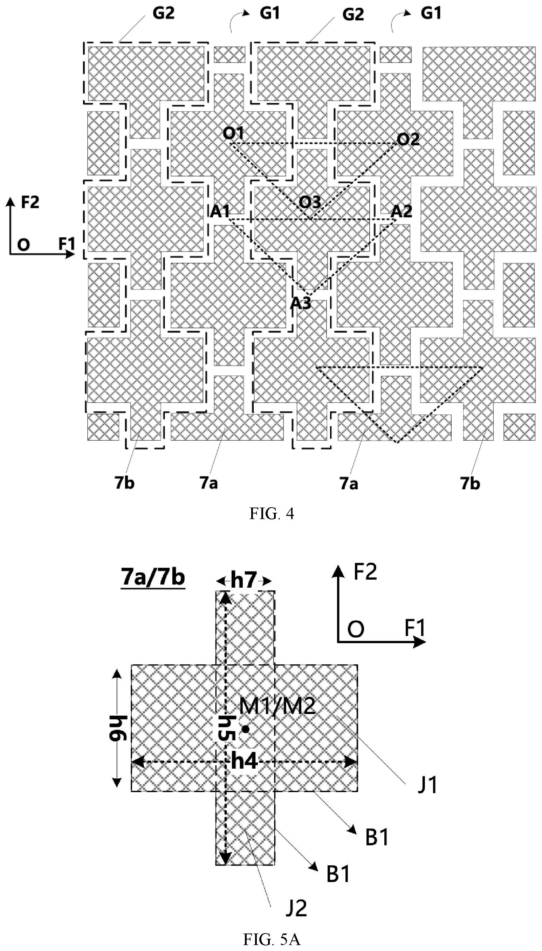

The embodiment of the present disclosure provides a display panel, including an active area AA and a peripheral area BB, the peripheral area BB surrounds the active area AA; with reference to FIG. 1A, FIG. 1B, FIG. 2 and FIG. 3, the display panel further includes:
a substrate 1 and a plurality of light emitting devices Q arranged in an array on the substrate 1, the plurality of light emitting devices Q being located at least in the active area AA;
a first conductive layer, including a first cathode ring 7 and anodes AN of the plurality of light emitting devices Q, wherein the first cathode ring 7 is located in the peripheral area BB and the first cathode ring 7 surrounds the active area AA, and the first cathode ring 7 is electrically connected to a pixel circuit 106 of the display panel;
wherein the first cathode ring 7 includes a plurality of conductive patterns (for example, 7a and 7b shown in FIG. 4), a gap is provided between two adjacent conductive patterns, and a plane figure of each of the conductive patterns includes a concave polygon.

The display panel includes the substrate 1 and a plurality of sub-pixels arranged in an array. The sub-pixels are located on the substrate 1, each sub-pixel includes a light emitting device Q and a color conversion layer, and the color conversion layer is located on the light emitting side of the light emitting device Q. Each light-emitting device Q includes a light-emitting functional layer EML, and a first electrode and a second electrode that are located on both sides of the light-emitting functional layer EML. Among them, for example, as shown in FIG. 3, one of the first electrode and the second electrode is the anode AN, and the other is the cathode 3. When the first electrode is the anode AN and the second electrode is the cathode 3, the first electrode is located between the light-emitting functional layer EML and the substrate 1, and at least a portion of the second electrode is located on the side of the light-emitting functional layer EML away from the first electrode. That is to say, the first electrode and the second electrode are located on both sides along a direction perpendicular to the light-emitting functional layer EML. The light-emitting functional layer EML not only includes film layers that directly emit light, but also includes functional film layers used for auxiliary luminescence, such as hole transport layers, electron transport layers, etc.

It should be noted that in the figures provided in the embodiments of the present disclosure, such as FIG. 2 and FIG. 3, for the sake of simplicity, the light-emitting functional layers EML of the light emitting devices Q are drawn to be connected together. In practical applications, when the emission colors of the light emitting devices Q are the same, the light-emitting functional layers EML of the light emitting devices Q can be connected together; when the emission colors of the light emitting devices Q are not completely the same, the light-emitting functional layers EML of the light emitting devices Q are separated by a pixel definition layer PDL to avoid color crosstalk between the sub-pixels.

When the first electrode is the anode and the second electrode is the cathode, the plurality of light emitting devices Q can share the second electrode, such as the cathode 3. For example, the cathode 3 can be formed from materials with high conductivity and low work function, such as metal materials. For example, the anode AN can be formed from a transparent conductive material with a high work function.

In an exemplary embodiment, the material of the first electrode may be indium tin oxide (ITO). Alternatively, the material of the first electrode may be titanium/aluminum/titanium/molybdenum (Ti/Al/Ti/Mo). Alternatively, the material of the first electrode may be titanium/silver/indium tin oxide (Ti/Ag/ITO). The specific details can be determined based on the actual situation, and there are no restrictions here.

In an exemplary embodiment, the material of the second electrode CA may be a combination of one or more materials from magnesium (Mg) and silver (Ag).

For example, the second electrode CA includes a magnesium layer/silver layer arranged in stacked, or alternatively, the second electrode CA includes a magnesium silver alloy layer.

In some examples, the driving baseplate 100 includes the substrate 1 and a driving unit located on the substrate, the driving unit includes a pixel circuit 106 and other conductive structures (such as signal lines and driving circuits).

In some examples, the material of the substrate 1 may be made of one or more materials from glass, polyimide, polycarbonate, polyacrylate, polyetherimide, and polyethersulfone, including but not limited to these.

In some examples, the substrate 1 may be a rigid substrate or a flexible substrate. When the substrate 1 is the flexible substrate, the substrate 1 may include a single layer of flexible material; alternatively, the substrate 1 may include a first flexible material layer, a first inorganic non-metallic material layer, a second flexible material layer, and a second inorganic non-metallic material layer that are stacked in sequence. The first flexible material layer and the second flexible material layer are made of materials such as polyimide (PI), polyethylene terephthalate (PET), or surface treated polymer soft film. The first inorganic non-metallic material layer and the second inorganic non-metallic material layer are made of materials such as silicon nitride (SiNx) or silicon oxide (SiOx), to improve the water and oxygen resistance of the substrate. The first inorganic non-metallic material layer and the second inorganic non-metallic material layer are also known as barrier layers.

When the substrate 1 is the rigid substrate, the substrate 1 may include a glass substrate or a silicon material substrate. When the substrate 1 is the silicon material substrate, multiple layers of conductive material and multiple layers of insulating material can be provided between the substrate 1 and the light emitting device Q, to form the driving circuit and the pixel circuit.

Among them, the silicon material substrate can be a P-type monocrystalline silicon substrate, or an N-type monocrystalline silicon substrate, which can be determined according to the actual product. It should be noted that the embodiments of the present disclosure are illustrated using a display panel with a silicon substrate as an example.

In some examples, other film layers may also be provided between the substrate 1 and the light emitting device Q, which may include a gate insulation layer, an interlayer insulation layer, various film layers in the pixel circuits (for example, including structures such as thin film transistors, storage capacitors), data lines, gate lines, power signal lines, reset power signal lines, reset control signal lines, light-emitting control signal lines, and other film layers or structures.

It should be noted that, as shown in FIG. 1A and FIG. 1B, an area delineated by an outer contour of an orthographic projection of the first cathode ring 7 on the substrate 1 is a closed area.

In the exemplary embodiment, the cathode 3 of the light emitting device Q in the active area AA is electrically connected to the first cathode ring 7 in the peripheral area BB.

The arrangement of the plurality of conductive patterns included in the first cathode ring 7 is not limited here. In some embodiments, the plurality of conductive patterns may be arranged in an array.

FIG. 4 illustrates a partial planar schematic diagram of the plurality of conductive patterns in a first cathode ring 7, in FIG. 4, the shapes of the plane figures of all conductive patterns are the same.

Among them, the concave polygon mentioned above refers to a polygon, when one of its edges is infinitely extended into a straight line in both directions, of which the other edges are not all on the same side of the straight line.

The concave polygons have the following characteristics:
1. having an interior angle greater than 180 °;
2. a line segment between two vertices of the polygon is located outside the polygon;
3. there are two vertices of the polygon, and the connecting line of the two vertices is not completely inside the polygon. "Not completely inside the polygon" means that the connecting line is partially located inside the polygon and partially located outside the polygon.

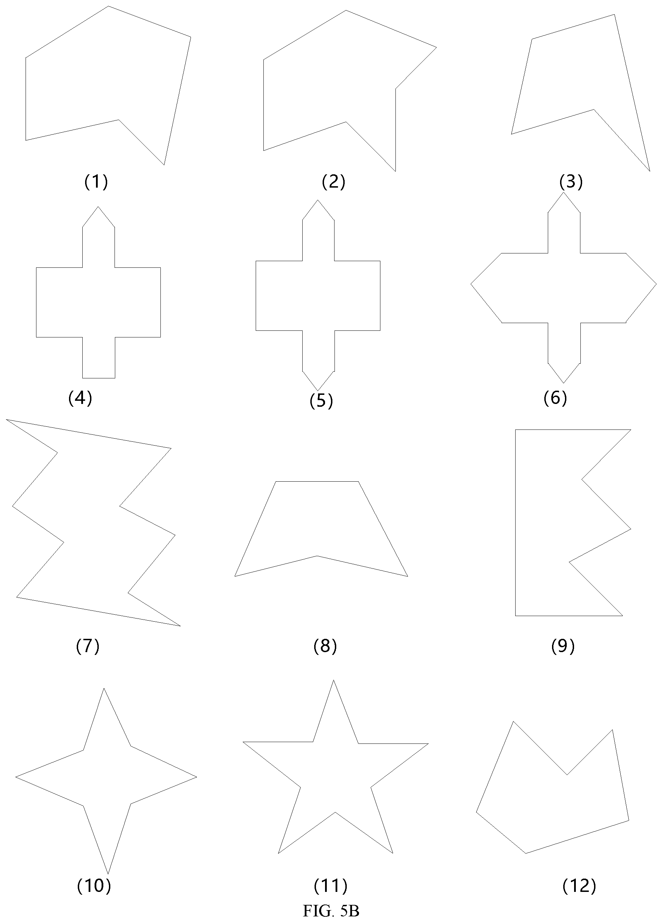

Among them, FIG. 5A provides a planar schematic diagram of a concave polygon, and FIG. 5B provides planar schematic diagrams of twelve concave polygons.

For example, the concave polygon may include a figure formed by splicing two rectangles as shown in FIG. 5A.

For example, the concave polygons may include the twelve figures provided in plan (1) to (12) of FIG. 5B, such as star shapes (including four-pointed stars, five-pointed stars, etc.), cross shapes, etc.

There is no restriction on whether the shapes of the orthographic projection figures (i.e., the shapes of the plane figures) of the plurality of conductive patterns on the substrate 1 are all the same. In some embodiments, the shapes of the plane figures of some conductive patterns are the same, while the shapes of the plane figures of some conductive patterns are different. In other embodiments, the shapes of the plane figures of all conductive patterns are the same.

FIG. 4 provided by the embodiment of the present disclosure takes the concave polygon shown in FIG. 5A as an example, to illustrate the arrangement of the plurality of conductive patterns in the first cathode ring 7.

In the display panel provided by the embodiment of the present disclosure, the first cathode ring 7 includes the plurality of conductive patterns, a gap is provided between two adjacent conductive patterns (such as 7a and 7b), and the plane figures of the plurality of conductive patterns (such as 7a or 7b) include the concave polygon. In this way, compared to convex polygons, the concave polygons have more vertex angles (tip structures) with relatively smaller angles. By setting multiple tip structures, it is beneficial to guide the accumulated static electricity away from the conductive path, thereby releasing static electricity and greatly reducing the risk of ESD in the display panel, thereby improving the yield, quality, and reliability of the display panel.

In at least one display panel provided by the embodiment of the present disclosure, as shown in FIG. 5A, and plan (4), plan (5) and plan (6) in FIG. 5B, shapes of orthographic projections of the plurality of conductive patterns (such as 7a or 7b) on the substrate 1 include a figure formed by splicing a first extension part and a second extension part together; and the first extension part extends along a first direction (such as OF1 direction), the second extension part extends along a second direction (such as OF2 direction), the first direction is a direction pointing from the active area AA to the peripheral area BB, and the second direction is perpendicular to the first direction.

The first direction (such as OF1 direction) is a direction pointing from the active area AA to the peripheral area BB, and the second direction (such as OF2 direction) is perpendicular to the first direction (such as OF1 direction). It should be noted that the OF1 direction is only one situation of the first direction. As the peripheral area BB surrounds the active area AA, the first direction can include a horizontal to right direction (such as the OF1 direction) as marked in FIG. 4, as well as a horizontal to left direction (the part of the peripheral area BB located on the left side of the active area AA), a horizontal upward direction (the part of the peripheral area BB located on the upper side of the active area AA), and a horizontal downward direction (the part of the peripheral area BB located on the lower side of the active area AA), and the second direction always remains perpendicular to the first direction.

In the exemplary embodiment, as shown in FIG. 5A, and plan (4), plan (5) and plan (6) in FIG. 5B, shapes of the first extension part and the second extension part are both roughly long strip shape.

In at least one display panel provided by the embodiment of the present disclosure, with reference to FIG. 4 and FIG. 5A, a plane figure of the first extension part is a first rectangle J1, and a plane figure of the second extension part is a second rectangle J2, and the shapes of the orthographic projections of the plurality of conductive patterns (such as 7a or 7b) on the substrate include a figure formed by splicing the first rectangle J1 and the second rectangle J2 together; and
a geometric center M1 of the first rectangle J1 overlaps with a geometric center M2 of the second rectangle J2, a first side B1 of the first rectangle J1 is perpendicular to a first side B1 of the second rectangle J2, and the first side B1 is a long side of a rectangle (refers to the first rectangle J1 and the second rectangle J2).

In at least one display panel provided by the embodiment of the present disclosure, as shown in FIG. 4, the plurality of conductive patterns include a first conductive pattern group G1 and a second conductive pattern group G2 that are alternately arranged along the first direction (such as OF1 direction), and the first conductive pattern group G1 and the second conductive pattern group G2 are both arranged around the active area AA; among them, FIG. 4 just shows a schematic diagram of a top view structure of a first cathode ring 7 located in a partial area on the right side of the active area AA;
the first conductive pattern group G1 includes a plurality of first conductive patterns 7a arranged along the second direction (such as OF2 direction), and the second conductive pattern group G2 includes a plurality of second conductive pattern 7b arranged along the second direction (such as OF2 direction); and
as shown in FIG. 4, a shape of a line connecting geometric centers (the geometric centers are O1 and O2, respectively) of two first conductive patterns 7a adjacent along the first direction (such as OF1 direction) and a geometric center (the geometric center is O3) of a second conductive pattern 7b between the two first conductive patterns 7a adjacent along the first direction is a first triangle 010203.

For example, as shown in FIG. 4, the geometric centers of the first conductive patterns 7a in the same row are located on a same straight line, and the geometric centers of the second conductive patterns 7b in the same row are located on a same straight line.

Specifically, as shown in FIG. 4, along the first direction (such as OF1 direction), the line connecting the geometric centers of the first conductive patterns 7a in the same row is the first straight line, and the first straight line does not overlap with the second conductive patterns 7b. The line connecting the geometric centers of the second conductive patterns 7b in the same row is a second straight line, and the second straight line does not overlap with the first conductive patterns 7a.

As shown in FIG. 4, along the second direction (such as OF2 direction), the line connecting the geometric centers of the first conductive patterns 7a in the same row is the third straight line, and the third straight line does not overlap with the second conductive patterns 7b. The line connecting the geometric centers of the second conductive patterns 7b in the same row is a fourth straight line, and the fourth straight line does not overlap with the first conductive patterns 7a.

In at least one display panel provided by the embodiment of the present disclosure, structures and sizes of the first conductive patterns 7a and the second conductive patterns 7b are the same.

In at least one display panel provided by the embodiment of the present disclosure, at least one side length of the first triangle 010203 is 3~5 times a maximum size of sub-pixels in the active area AA.

For example, a range of the maximum size of one sub-pixel in the active area AA is 5µm ~10µm.

For example, a range of the at least one side length of the first triangle 010203 is 15µm~50µm.

In at least one display panel provided by the embodiment of the present disclosure, the range of the at least one side length of the first triangle 010203 is 15µm~30µm.

For example, in the first triangle 010203, length ranges of the side O1O2 and the side 0103 are both 15µm~30µm.

For example, in the first triangle 010203, length ranges of the side 0102, the side 0103 and the side O2O3 are all 15µm~30µm.

For example, in the first triangle 010203, the length range of the side O1O2 is 15µm~30µm. For example, the length of the side O1O2 is 16µm, 17µm, 18µm, 19µm, 20µm, 21µm, 22µm, 23µm, 24µm, 25µm, 26µm, 27µm, 28µm, 29µm or 30µm.

For example, the lengths of the side 0103 and the side O2O3 are both less than the length of the side 0102.

In the embodiment of the present disclosure, when at least one side length of the first triangle 010203 is 3~5 times the maximum size of the sub-pixels in the active area AA, the size of the conductive pattern is not significantly different from the size of one sub-pixel in the active area AA, which can improve the uniformity of the distributions of the sub-pixels in the active area AA and the conductive patterns of the first cathode ring 7 in the peripheral area BB in the display panel, thereby improving optical uniformity, enhancing the display effect and image quality of the display panel.

When the sizes of the conductive patterns in the peripheral area BB relative to the sub-pixels are too large, it may result in poor size uniformity of the structures in the active area AA and the peripheral area BB of the display panel, which may cause significant differences in optical properties (such as transmittance and reflectivity) and reduce the display effect of the display panel. When the sizes of the conductive patterns in the peripheral area BB relative to the sub-pixels are too small, the contact resistance in the electrical connection path between the conductive pattern and the pixel electrode is too high, which reduces the conductivity characteristics of the display panel, causes the stability of the transmission of lines in the display panel to deteriorate, and reduces the display effect of the display panel.

In at least one display panel provided by the embodiment of the present disclosure, the first triangle 010203 is an isosceles triangle.

For example, the lengths of the side 0103 and the side O2O3 are equal.

For example, when the lengths of the side 0103 and the side O2O3 are equal and the structures and the sizes of the first conductive patterns 7a and the second conductive patterns 7b are the same, as shown in FIG. 4, a shape of a line connecting geometric centers of two second conductive patterns 7b adjacent along the first direction (such as OF1 direction) and a geometric center of a first conductive pattern 7a between the two second conductive patterns 7b adjacent along the first direction (such as OF1 direction) is also the first triangle (the triangle shown in the bottom right corner of FIG. 4).

For example, when the lengths of the side 0103 and the side 0203 are equal, a distance between the geometric center of any first conductive pattern 7a along the first direction (such as OF1 direction) and the geometric center of an adjacent second conductive pattern 7b is roughly equal to half the length of the side O1O2. A distance between the geometric center of any second conductive pattern 7b along the first direction (such as OF1 direction) and the geometric center of an adjacent first conductive pattern 7a is roughly equal to half the length of the side 0102.

In at least one display panel provided by the embodiment of the present disclosure, as shown in FIG. 5A, the first side B1 of the first rectangle J1 extends along the first direction (such as OF1 direction), the first side B1 of the second rectangle J2 extends along the second direction (such as OF2 direction), and an area of the first rectangle J1 is greater than an area of the second rectangle J2.

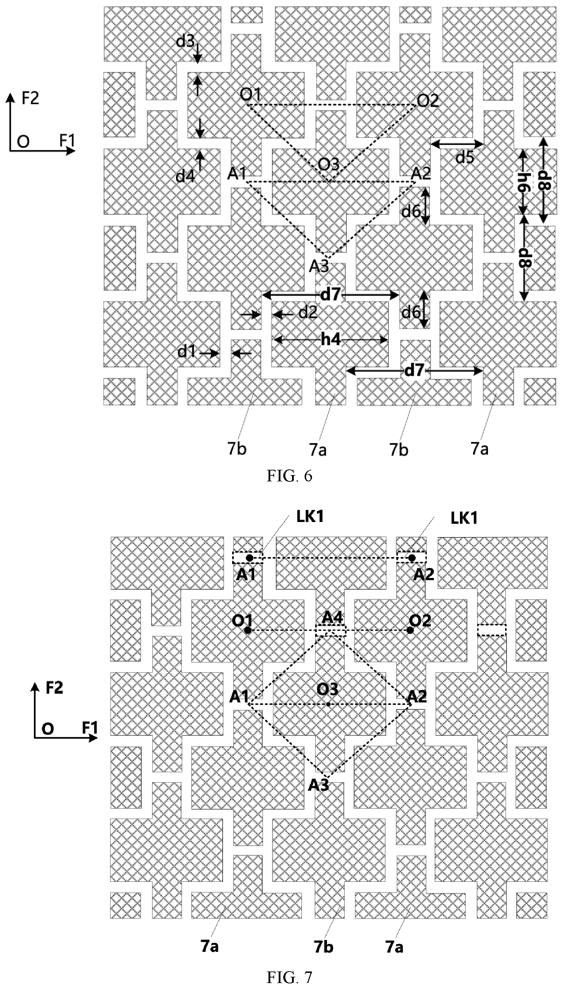

In at least one display panel provided by the embodiment of the present disclosure, as shown in FIG. 6, along the first direction (such as OF1 direction), a minimum distance between the second conductive pattern 7b and the first conductive pattern 7a that is on a side close to the active area AA is a first distance d1, a minimum distance between the second conductive pattern 7b and the first conductive pattern 7a that is on a side away from the active area AA is a second distance d2, and the first distance d1 and the second distance d2 are roughly equal. It should be noted that, FIG. 6 to FIG. 10 all show schematic diagrams of partial top view structures of the first cathode rings 7 in the part of the peripheral area BB on the right of the active area AA.

In the exemplary embodiment, when the structures and sizes of the first conductive patterns 7a and the second conductive patterns 7b are the same, it can be understood that the first conductive patterns 7a and the second conductive patterns 7b are only named differently for the purpose of illustrating the arrangement pattern of the conductive patterns in the first cathode ring 7. The first conductive pattern 7a and the second conductive pattern 7b actually have the same structure.

Therefore, at this point, in some embodiments, the minimum distance between the first conductive pattern 7a and the second conductive pattern 7b that is on the side close to the active area AA along the first direction (such as OF1 direction) is the first distance d1, the minimum distance between the first conductive pattern 7a and the second conductive pattern 7b that is on the side away from the active area AA is the second distance d2, and the first distance d1 and the second distance d2 are roughly equal.

In at least one display panel provided by the embodiment of the present disclosure, as shown in FIG. 6, along the second direction (such as OF2 direction), a minimum distance between the second conductive pattern 7b and the first conductive pattern 7a on one side of the second conductive pattern 7b is a third distance d3, a minimum distance between the second conductive pattern 7b and the first conductive pattern 7a on another side of the second conductive pattern 7b is a fourth distance d4, and the third distance d3 and the fourth distance d4 are roughly equal.

In some embodiments, along the second direction (such as OF2 direction), a minimum distance between the first conductive pattern 7a and the second conductive pattern 7b on one side of the first conductive pattern 7a is the third distance d3, a minimum distance between the first conductive pattern 7a and the second conductive pattern 7b on another side of the first conductive pattern 7a is the fourth distance d4, and the third distance d3 and the fourth distance d4 are roughly equal.

In the display panel provided by the embodiment of the present disclosure, by setting that the first distance d1 and the second distance d2 are roughly equal, and the third distance d3 and the fourth distance d4 are roughly equal, it can greatly improve the distribution uniformity of the conductive patterns in the first cathode ring 7, thereby uniformly reducing the probability of ESD occurrence in the conductive patterns at various positions in the first cathode ring 7, greatly reducing the risk of ESD occurrence in the display panel, and thus improving the yield, quality, and reliability of the display panel.

In at least one display panel provided by the embodiment of the present disclosure, ranges of the first distance d1, the second distance d2, the third distance d3 and the fourth distance d4 are all 0.5~2 times a maximum size of sub-pixels in the active area AA.

For example, a range of the maximum size of one sub-pixel in the active area AA is 5µm ~10µm.

In at least one display panel provided by the embodiment of the present disclosure, the ranges of the first distance d1, the second distance d2, the third distance d3 and the fourth distance d4 are 2.5µm~20µm.

In at least one display panel provided by the embodiment of the present disclosure, the ranges of the first distance d1, the second distance d2, the third distance d3 and the fourth distance d4 are all 5µm~10µm.

For example, the first distance d1 and the second distance d2 may both be 6µm, 6.5µm, 7µm, 7.5µm, 8µm, 8.5µm, 9µm or 9.5µm.

For example, the third distance d3 and the fourth distance d4 may both be 6µm, 6.5µm, 7µm, 7.5µm, 8µm, 8.5µm, 9µm or 9.5µm.

In at least one display panel provided by the embodiment of the present disclosure, as shown in FIG. 6, the first distance d1, the second distance d2, the third distance d3 and the fourth distance d4 are all roughly equal.

In the display panel provided by the embodiment of the present disclosure, by setting that the first distance d1, the second distance d2, the third distance d3 and the fourth distance d4 are roughly equal, it can greatly improve the distribution uniformity of the conductive patterns in the first cathode ring 7, thereby uniformly reducing the probability of ESD occurrence in the conductive patterns at various positions in the first cathode ring 7, greatly reducing the risk of ESD occurrence in the display panel, and thus improving the yield, quality, and reliability of the display panel.

In at least one display panel provided by the embodiment of the present disclosure, a length of the first side B1 of the first rectangle J1 is less than or equal to a length of the first side B1 of the second rectangle J2, and the length of the first side B1 of the second rectangle J2 is greater than 0.5 times the length of the first side B1 of the first rectangle J1.

In the embodiment of the present disclosure, by setting that the length of the first side B1 of the second rectangle J2 is greater than 0.5 times the length of the first side B1 of the first rectangle J1, the difference between the maximum size along the first direction and the maximum size along the second direction of the conductive pattern of the concave polygon is not significant. Therefore, in the conductive path between the first cathode ring 7 and the pixel circuit 106, the resistance along the first direction and the second direction can be better balanced, thereby improving the uniformity of resistance in the display panel and enhancing the driving characteristics of the display panel.

In at least one display panel provided by the embodiment of the present disclosure, as shown in FIG. 5A, the length h4 of the first side B1 of the first rectangle J1 is less than or equal to the length h5 of the first side B1 of the second rectangle J2, and a range of the length h4 of the first side B1 of the first rectangle J1 is 30µm~50µm.

For example, the length h4 of the first side B1 of the first rectangle J1 is less than the length h5 of the first side B1 of the second rectangle J2.

For example, the length h4 of the first side B1 of the first rectangle J1 is equal to the length h5 of the first side B1 of the second rectangle J2.

For example, the length h4 of the first side B1 of the first rectangle J1 is 32µm, 35µm, 38µm, 40µm, 43µm, 45µm, 48µm or 49µm.

In at least one display panel provided by the embodiment of the present disclosure, a maximum width of the first extension part along the second direction (such as OF2 direction) is greater than a maximum width of the second extension part along the first direction (such as OF1 direction).

For example, when the first extension part and the second extension part are both rectangle, in at least one display panel provided by the embodiment of the present disclosure, as shown in FIG. 5A, the length h6 of the second side of the first rectangle J1 is greater than the length h7 of the second side of the second rectangle J2, the second side is a short side of the rectangle, and a range of the length h6 of the second side of the first rectangle J1 is 20µm~30µm.

For example, the length h6 of the second side of the first rectangle J1 may be 22µm, 23µm, 24µm, 25µm, 26µm, 27µm, 28µm or 29µm.

In the embodiment of the present disclosure, by setting that the maximum width of the first extension part along the second direction (such as OF2 direction) is greater than the maximum width of the second extension part along the first direction (such as OF1 direction), it may be beneficial for reduce the resistance (i.e., the direction of current transmission) of the first cathode ring 7 along the first direction (such as OF1 direction) in the conduction path with the pixel circuit 106, and improve the conductivity, where the direction of current transmission is a direction from the pixel circuit 106 towards the first cathode ring 7.

In at least one display panel provided by the embodiment of the present disclosure, as shown in FIG. 5A, in the first rectangle J1 and the second rectangle J2, the length of the first side is greater than a length of a second side, that is, h4 is greater than h6, h5 is greater than h7; and an absolute value of a difference between the length h4 of the first side B1 of the first rectangle J1 and the length h6 of the second side of the first rectangle J1 is greater than or equal to 0.5~2 times a maximum size of sub-pixels in the active area AA.

For example, a range of the maximum size of one sub-pixel in the active area AA is 5µm ~10µm.

For example, the absolute value of the difference between the length h4 of the first side B1 of the first rectangle J1 and the length h6 of the second side of the first rectangle J1 is greater than or equal to a first parameter, and a range of the first parameter is 0.25µm~20µm.

For example, the absolute value of the difference between the length h4 of the first side B1 of the first rectangle J1 and the length h6 of the second side of the first rectangle J1 is greater than or equal to the first parameter, and the range of the first parameter is 5µm~15µm.

For example, the absolute value of the difference between the length h4 of the first side B1 of the first rectangle J1 and the length h6 of the second side of the first rectangle J1 is greater than or equal to 7µm, 8µm, 9µm, 10µm, 11µm, 12µm, 13µm or 14µm.

For example, the absolute value of the difference between the length h5 of the first side of the second rectangle J2 and the length h7 of the second side of the second rectangle J2 is greater than or equal to a second parameter, and a range of the second parameter is the same as that of the first parameter.

For example, the second parameter is greater than or equal to the first parameter.

In at least one display panel provided by the embodiment of the present disclosure, as shown in FIG. 6, for the first conductive pattern 7a and the second conductive pattern 7b adjacent along the first direction (such as OF1 direction), a minimum distance from the first side (the long side) of the second rectangle J2 in the first conductive pattern 7a to the first side (the long side) of the second rectangle J2 in the second conductive pattern 7b is a fifth distance d5; a minimum distance from the first side (the long side) of the second rectangle J2 in the second conductive pattern 7b to the first side (the long side) of the second rectangle J2 in the first conductive pattern 7a is the fifth distance d5; in the same conductive pattern, a minimum distance between the first side (the long side) of the first rectangle J1 and the second side (short side) of the second rectangle J2 is a sixth distance d6; the fifth distance d5 is greater than the sixth distance d6.

In at least one display panel provided by the embodiment of the present disclosure, as shown in FIG. 6, a range of the fifth distance d5 is 8µm ~15µm, and a range of the sixth distance d6 is 6µm ~12pum.

For example, the fifth distance d5 may be 9µm, 10µm, 11µm, 12µm, 13µm or 14µm.

For example, the sixth distance d6 may be 7µm, 8µm, 9µm, 10µm, 11µm or 12µm.

In at least one display panel provided by the embodiment of the present disclosure, as shown in FIG. 6, for two first conductive patterns 7a adjacent along the first direction (such as OF1 direction), a minimum distance between the first sides (the long sides) of the second rectangles J2 in the two first conductive patterns 7a is a seventh distance d7; for two second conductive patterns 7b adjacent along the first direction (such as OF1 direction), a minimum distance between the first sides (the long sides) of the second rectangles J2 in the two second conductive patterns 7b is the seventh distance d7;

for two first conductive patterns 7a adjacent along the second direction (such as OF2 direction), a minimum distance between the first sides (the long sides) of the first rectangles J1 in the two first conductive patterns 7a is an eighth distance d8; for two second conductive patterns 7b adjacent along the second direction (such as OF2 direction), a minimum distance between the first sides (the long sides) of the first rectangles J1 in the two second conductive pattern 7b is the eighth distance d8; where the seventh distance d7 is greater than or equal to the eighth distance d8.

For example, the seventh distance d7 is greater than the eighth distance d8.

For example, the seventh distance d7 is equal to the eighth distance d8.

In at least one display panel provided by the embodiment of the present disclosure, as shown in FIG. 6, a ratio (d7/h4) of a length of the seventh distance d7 to a length h4 of the first side (the long side) of the first rectangle J1, is greater than or equal to a ratio (d8/h6) of a length of the eighth distance d8 to a length h6 of a second side (the short side) of the first rectangle J1, that is, d7/h4≥d8/h6.

In the embodiment of the present disclosure, by setting d7/h4≥d8/h6, it can be understood that, when h4 is equal to h6, d7 is greater than or equal to d8. That is, the size of the gap between two adjacent conductive patterns along the first direction (such as OF1 direction) is greater than the size of the gap between two adjacent conductive patterns along the second direction (such as OF2 direction), thereby avoiding direct contact and conduction between two adjacent conductive patterns along the first direction (such as OF1 direction) as much as possible, which may further reduce the probability of ESD occurrence in the conductive patterns at various positions in the first cathode ring 7, greatly reduce the risk of ESD occurrence in the display panel, and thus improving the yield, quality, and reliability of the display panel.

In at least one display panel provided by the embodiment of the present disclosure, as shown in FIG. 7, a first hollow area LK1 is provided between two conductive patterns adjacent along the second direction (such as OF2 direction).

For example, a first hollow area LK1 is provided between two first conductive patterns 7a adjacent along the second direction (such as OF2 direction).

For example, a first hollow area LK1 is provided between two second conductive patterns 7b adjacent along the second direction (such as OF2 direction).

Among them, a line connecting geometric centers of two first hollow areas LK1 adjacent along the first direction (such as OF1 direction) and a geometric center of a conductive pattern between the two first hollow areas LK1 adjacent along the first direction (such as OF1 direction) is a first line segment (such as the line segment A1A2 marked in FIG. 7); and a line connecting the geometric centers of the two first conductive patterns 7a adjacent along the first direction (such as OF1 direction) is a second line segment (such as the line segment 0102 marked in FIG. 7); the first line segment A1A2 is parallel to the second line segment 0102.

In the exemplary embodiment, a line connecting the geometric centers of the two first hollow areas LK1 adjacent along the first direction (such as OF1 direction) is the first line segment; a line connecting the geometric centers of the two first conductive patterns 7a adjacent along the first direction (such as OF1 direction) is the second line segment, a line connecting the geometric centers of the two second conductive patterns 7b adjacent along the first direction (such as OF1 direction) is also the second line segment, any first line segment and the second line segment are disposed parallel to each other, and the extension directions of the first line segment and the second line segment are consistent with the first direction (such as OF1 direction).

In at least one display panel provided by the embodiment of the present disclosure, as shown in FIG. 7, a length of the first line segment and a length of the second line segment are roughly equal.

In the exemplary embodiment, the geometric centers of any two first hollow areas LK1 adjacent along the second direction (such as OF2 direction) and the geometric centers of the conductive patterns (including the first conductive pattern 7a or the second conductive pattern 7b) between these two first hollow areas LK1 are located on the same straight line.

In at least one display panel provided by the embodiment of the present disclosure, as shown in FIG. 7, two first hollow areas LK1 arranged along the first direction (such as OF1 direction) and located on two sides of the first rectangle J1, and two first hollow areas LK1 arranged along the second direction (such as OF2 direction) and located on two sides of the second rectangle J2 are disposed around the same conductive pattern (such as the same second conductive pattern 7b or the same first conductive pattern 7a); and

a shape formed by a line connecting geometric centers of four first hollow areas LK1 around the same conductive pattern (such as the same second conductive pattern 7b or the same first conductive pattern 7a) in sequence is a quadrilateral (such as the quadrilateral A1A3A2A4 shown in FIG. 7), the quadrilateral A1A3A2A4 includes two second triangles (such as the second triangle A1A2A3 and the second triangle A1A2A4), and the two second triangles are the same as the first triangle 010203 shown in FIG. 6.

The second triangle and the first triangle are the same, which refers to the fact that the shapes and sizes of the two triangles are the same, and is not limited to their arrangement direction or arrangement position being the same.

For example, the arrangement direction of the second triangle A1A2A3 is the same as that of the first triangle 010203, and the second triangle A1A2A4 is symmetrically arranged with the first triangle 010203.

In the display panel provided by the embodiment of the present disclosure, by setting that the two second triangles (that is, the second triangle A1A2A3 and the second triangle A1A2A4) shown in FIG. 7 are the same as the first triangle 010203 shown in FIG. 6, it can greatly improve the distribution uniformity of the conductive patterns in the first cathode ring 7, thereby uniformly reducing the probability of ESD occurrence in the conductive patterns at various positions in the first cathode ring 7, greatly reducing the risk of ESD occurrence in the display panel, and thus improving the yield, quality, and reliability of the display panel.

In at least one display panel provided by the embodiment of the present disclosure, the peripheral area BB of the display panel further includes a plurality of auxiliary electrodes (such as W vial and W via2), two adjacent auxiliary electrodes (such as two adjacent W vial or two adjacent W via2) arranged along the first direction (pointing from the active area AA to the peripheral area BB) are not in contact with each other, the orthographic projections of the plurality of conductive patterns (such as 7a and 7b) on the substrate 1 overlap with orthographic projections of the plurality of auxiliary electrodes (such as W vial and W via2) on the substrate 1, and the plurality of conductive patterns (such as 7a and 7b) are electrically connected to the plurality of auxiliary electrodes (such as W vial and W via2).

In the exemplary embodiment, along the direction pointing from the active area AA to the peripheral area BB, the number of the conductive patterns included in the conductive pattern group gradually increases.

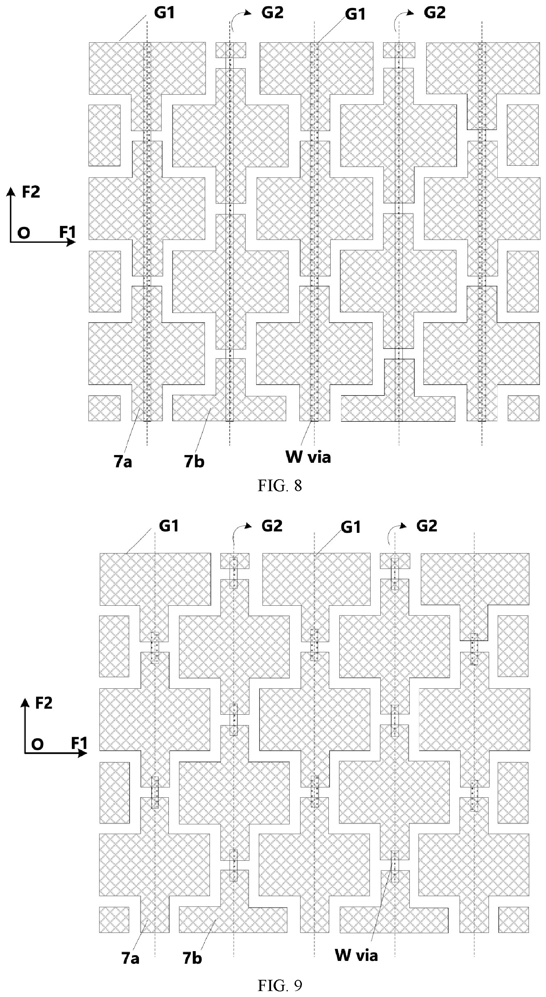

In at least one display panel provided by the embodiment of the present disclosure, as shown in FIG. 8, FIG. 9 and FIG. 10, the same group of conductive patterns (including the first conductive pattern group G1 or the second conductive pattern group G2) are electrically connected to the pixel circuit 106 through one or more auxiliary electrodes (W via, including W via 1 and/or W via 2). The orthographic projection of the same group of conductive patterns (including the first conductive pattern group G1 or the second conductive pattern group G2) on the substrate 1 overlaps with the orthographic projections of the plurality of auxiliary electrodes (W via, including W via 1 or W via 2) on the substrate 1.

For example, the orthographic projection of the same first conductive pattern group G1 on the substrate 1 overlaps with the orthographic projections of the plurality of auxiliary electrodes (such as W via 1 and/or W via 2) on the substrate 1.

For example, the orthographic projection of the same second conductive pattern group G2 on the substrate 1 overlaps with the orthographic projections of the plurality of auxiliary electrodes (such as W via 1 and/or W via 2) on the substrate 1.

In the exemplary embodiment, when the orthographic projection of the same group of conductive patterns (including the first conductive pattern group G1 or the second conductive pattern group G2) on the substrate 1 overlaps with the orthographic projections of the plurality of auxiliary electrodes (such as W via 1 and/or W via 2) on the substrate 1, along the direction pointing from the active area AA to the peripheral area BB, the number of the auxiliary electrodes (such as W via 1 and/or W via 2), of which the orthographic projections on the substrate 1 overlap with the orthographic projection of the same group of conductive patterns on the substrate 1, gradually increases.

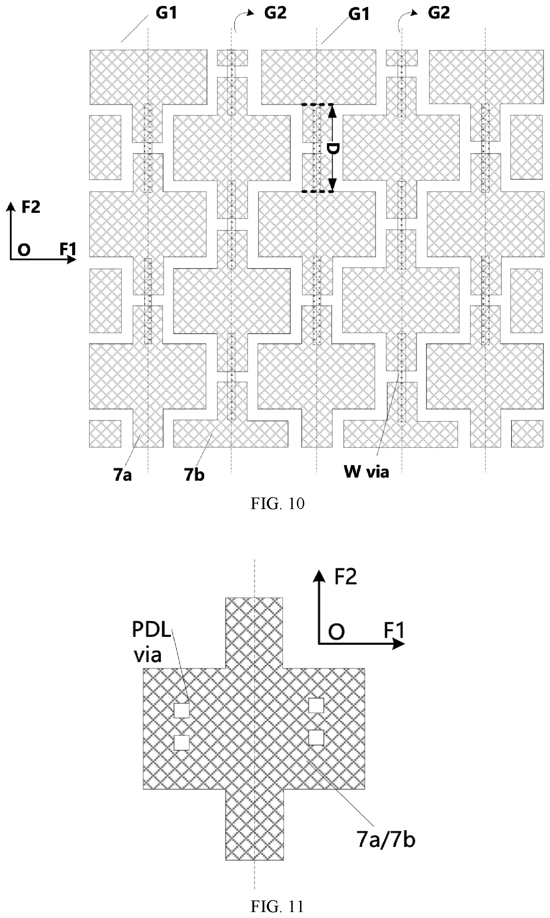

For example, as shown in FIG. 10, the length D of one auxiliary electrode (such as W vial or W via2) along the second direction (such as OF2 direction) is roughly equal to the distance between the two first sides (long sides) of the first rectangles of two adjacent conductive patterns.

In at least one display panel provided by the embodiment of the present disclosure, as shown in FIG. 8, FIG. 9 and FIG. 10, the plane figures of the plurality of conductive patterns are axisymmetric shapes, the plurality of conductive patterns have first axes of symmetry (the dashed lines drawn in FIG. 8, FIG. 9 and FIG. 10) extending along the second direction (such as OF2 direction); areas where the first axes of symmetry are located overlap with areas where the orthographic projections of the plurality of auxiliary electrodes (such as W vial and/or W via2) on the substrate 1 are located.

In the exemplary embodiment, by setting that the areas where the first axes of symmetry are located overlap with the areas where the orthographic projections of the plurality of auxiliary electrodes (such as W vial and/or W via2) on the substrate 1 are located, the auxiliary electrode (such as W vial or W via2) overlaps and is electrically connected to the area close to the central axis of the conductive pattern, which avoids the electrical connection between two conductive patterns adjacent along the first direction through the auxiliary electrode (such as W vial or W via2) when the preparation process is unstable or the alignment accuracy deviates, thereby further reducing the risk of ESD occurrence in the display panel, and thus improving the yield, quality, and reliability of the display panel.

In at least one display panel provided by the embodiment of the present disclosure, as shown in FIG. 3, the display panel further includes a pixel definition layer PDL and a cathode layer 3 located on one side of the pixel definition layer PDL away from the substrate 1, a part of the pixel definition layer PDL located in the peripheral area BB includes a plurality of first through-holes PDL via; the first cathode ring 7 is disposed at bottoms of the plurality of first through-holes PDL via; and a part area of the cathode layer 3 falls into the plurality of first through-holes PDL via and is electrically connected to the plurality of conductive patterns through the plurality of first through-holes PDL via.

FIG. 11, FIG. 12, and FIG. 13 illustrate top view structural diagrams of three positional relationships between the first through-hole PDL via and conductive pattern 7a or 7b. Certainly, the position distribution of the plurality of first through-holes PDL via is not limited to the above description and can also be adjusted according to actual situations.

For example, the material of the pixel definition layer PDL may include organic materials such as polyimide, acrylic, or polyethylene terephthalate. The specific setting position and structure of the pixel definition layer PDL located in the active area AA can refer to related art, and will not be repeated here.

In the exemplary embodiment, the area enclosed by the orthographic projection of the outer contour of the first through-holes PDL via on the substrate 1 does not completely overlap with the orthographic projection of the auxiliary electrodes (such as W via 1 and/or W via 2) on the substrate 1.

In this specification, descriptions such as "not completely overlap" and "not completely the same" include at least two situations: firstly, they are partial overlapping, and/or they are partial non-overlapping; secondly, they are completely non-overlapping. Alternatively, firstly, they are partial the same, and/or they are partial different; secondly, they are completely different.

In at least one display panel provided by the embodiment of the present disclosure, with reference to FIG. 2 and FIG. 3, the display panel further includes a driving baseplate 100, the driving baseplate 100 includes the substrate 1 and a driving unit, and the driving unit is located between the substrate 1 and the first conductive layer (including the first cathode ring 7 and the anodes AN of the light emitting devices); and a part of the driving unit located in the peripheral area BB includes a second cathode ring 102, a part of the driving unit located in the active area AA includes a pixel circuit 106, the second cathode ring 102 is electrically connected to the first cathode ring 7 and the pixel circuit 106, respectively; an orthographic projection of the second cathode ring 102 on the substrate 1 is located within an orthographic projection of the first cathode ring 7 on the substrate 1.

In the exemplary embodiment, an orthographic projection of the second cathode ring 102 on the substrate 1 is located within an orthographic projection of the first cathode ring 7 on the substrate 1, including but not limited to the following situations:

Firstly, a contour of the orthographic projection of the second cathode ring 102 on the substrate 1 is located within a contour of the orthographic projection of the first cathode ring 7 on the substrate 1.

Secondly, the contour of the orthographic projection of the second cathode ring 102 on the substrate 1 overlaps with the contour of the orthographic projection of the first cathode ring 7 on the substrate 1.

In practical applications, the driving baseplate 100 includes multiple metal layers and an insulating layer located between any two adjacent metal layers. The second cathode ring 102 can be placed in any one or more metal layers of the driving baseplate 100.

For example, the driving baseplate 100 includes six metal layers, or alternatively, the driving baseplate 100 includes eight metal layers. Taking the driving baseplate 100 including six metal layers as an example, the six metal layers are respectively the first metal layer, the second metal layer, the third metal layer, the fourth metal layer, the fifth metal layer, and the sixth metal layer sequentially arranged on the substrate 1. The distance between the sixth metal layer and the first cathode ring 7 is the smallest, and the distance between the first metal layer and the first cathode ring 7 is the largest. Among them, the second cathode ring 102 may be placed in a metal layer with a smaller distance from the first cathode ring 7. For example, the second cathode ring 102 may be placed on the fifth metal layer and the sixth metal layer. For another example, the second cathode ring 102 may be placed on the sixth metal layer.

For example, taking the driving baseplate 100 including six metal layers as an example, the metal layer marked as 101 in FIG. 3 may be any one of the first metal layer, the second metal layer, the third metal layer, and the fourth metal layer, which is used to electrically connect the second cathode ring 102 to the pixel circuit 106 in the active area AA.

In at least one display panel provided by the embodiment of the present disclosure, a width of the second cathode ring 102 along the first direction (such as OF1 direction ) is less than a width of the first cathode ring 7 along the first direction (such as OF1 direction ), and structures of the conductive patterns in the second cathode ring 102 are the same as that of the conductive patterns in the first cathode ring 7.

In the exemplary embodiment, the width of the second cathode ring 102 along the first direction (such as OF1 direction ) is less than a width of the first cathode ring 7 along the first direction (such as OF1 direction ), including but not limited to the following situations:

Firstly, a number of the groups of the conductive patterns in the second cathode ring 102 is the same as a number of the groups of the conductive patterns in the first cathode ring 7, the structures of the conductive patterns in the second cathode ring 102 are the same as that of the conductive patterns in the first cathode ring 7, and the sizes of the conductive patterns in the second cathode ring 102 along the first direction (such as OF1 direction ) are less than the sizes of the conductive patterns in the first cathode ring 7 along the first direction (such as OF1 direction ).

Secondly, the number of the groups of the conductive patterns in the second cathode ring 102 is less than the number of the groups of the conductive patterns in the first cathode ring 7, and the structures and sizes of the conductive patterns in the second cathode ring 102 are the same as that of the conductive patterns in the first cathode ring 7.

In the exemplary embodiment, the pixel circuit 106 may include two transistors and one capacitor (2T1C); alternatively, the pixel circuit 106 may include four transistors and one capacitor (4T1C); alternatively, the pixel circuit 106 may include five transistors and one capacitor (5T1C). The embodiment of the pixel circuit 106 in the present disclosure is not limited to this. In other embodiments, the pixel circuit 106 may also include more transistors, more capacitors, or other devices.

In addition, there is no restriction on the type of the transistor in the pixel circuit 106 mentioned above. For example, the transistors may include an N-type transistor; alternatively, the transistors may include a P-type transistor; alternatively, the transistors may include both the N-type transistor and the P-type transistor simultaneously.

When the substrate 1 is a silicon material substrate, multiple layers of conductive material and multiple layers of insulating material can be provided between the substrate 1 and the light emitting devices Q, to form the driving circuit and the pixel circuit. Among them, the substrate 1, as well as the driving circuit and the pixel circuit that are located on the substrate 1 can be collectively referred to as driving baseplate 100 (or driving back panel). The driving back panel can be a field-effect transistor driven back panel (MOS driving back panel), where the metal layers in the MOS driving back panel are separated by insulating layers (such as the first insulating layer 8 and the second insulating layer 9 shown in FIG. 2) and electrically connected through tungsten holes (W via).

In at least one display panel provided by the embodiment of the present disclosure, as shown in FIG. 3, a part of the driving unit located in the peripheral area BB further includes a plurality of auxiliary electrodes, the plurality of auxiliary electrodes includes a plurality of first connecting electrodes W vial and a plurality of second connecting electrodes W via2, the driving baseplate includes a second conductive layer (the film layer where a conductive structure 101 is located), and the second conductive layer is located between the plurality of second connecting electrodes W via2 and the substrate 1; and the plurality refers to at least two.

In the exemplary embodiment, the plurality of first connecting electrodes W vial and the plurality of second connecting electrodes W via2 may both be columnar connection circuits, and the columnar may include cylinders and prisms.

The plurality of first connecting electrodes W vial are located between the first cathode ring 7 and the second cathode ring 102, and the plurality of first connecting electrodes W vial contact and are electrically connected to the first cathode ring 7 and the second cathode ring 102, respectively; the plurality of second connecting electrodes W via2 are located between the second conductive layer (the film layer where the conductive structure 101 is located) and the second cathode ring 102, the plurality of second connecting electrodes W via2 contact and are electrically connected to the second cathode ring 102 and the second conductive layer (the film layer where the conductive structure 101 is located), respectively, and the second conductive layer is electrically connected to the pixel circuit 106.

In the exemplary embodiment, the plurality of first connecting electrodes W vial and the plurality of second connecting electrodes W via2 may also be referred to as tungsten holes.

For example, taking the driving baseplate 100 including six metal layers as an example, the six metal layers are respectively the first metal layer, the second metal layer, the third metal layer, the fourth metal layer, the fifth metal layer, and the sixth metal layer sequentially arranged on the substrate 1. The distance between the sixth metal layer and the auxiliary electrodes (such as W vial or W via2) is the smallest, and the distance between the first metal layer and the auxiliary electrodes (such as W vial or W via2) is the largest. The metal layer marked as 101 in FIG. 3 may be any one of the first metal layer, the second metal layer, the third metal layer, and the fourth metal layer, which is used to electrically connect the second cathode ring 102 to the pixel circuit 106 in the active area AA.

In at least one display panel provided by the embodiment of the present disclosure, for the plurality of auxiliary electrodes (such as W vial and/or W via2) overlapping with the same conductive pattern, a quantity of a plurality of auxiliary electrodes overlapping with the first rectangle J1 is greater than or equal to a quantity of a plurality of auxiliary electrodes overlapping with the second rectangle J2.

For example, for the plurality of auxiliary electrodes (such as W vial and/or W via2) overlapping with the same conductive pattern in the first cathode ring 7, the quantity of the plurality of auxiliary electrodes overlapping with the first rectangle J1 is greater than or equal to the quantity of the plurality of auxiliary electrodes overlapping with the second rectangle J2.

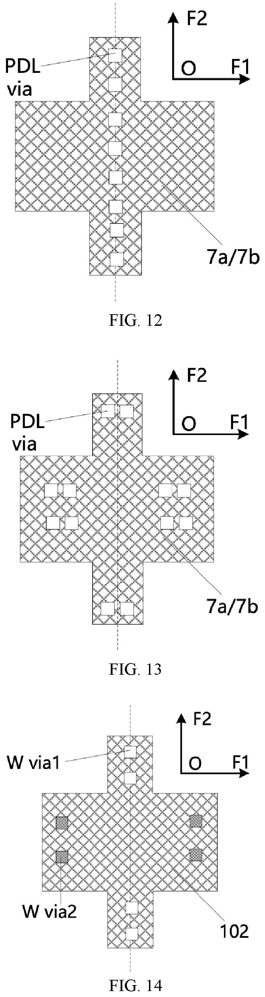

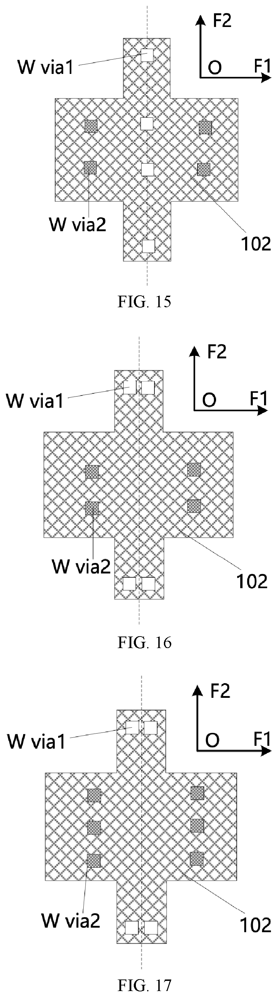

For example, as shown in FIG. 14, FIG. 15, FIG. 16, and FIG. 17, for the plurality of auxiliary electrodes (such as W vial and/or W via2) overlapping with the same conductive pattern in the second cathode ring 102, the quantity of the plurality of auxiliary electrodes overlapping with the first rectangle J1 is greater than or equal to the quantity of the plurality of auxiliary electrodes overlapping with the second rectangle J2.

In the embodiment of the present disclosure, for the plurality of auxiliary electrodes (such as W vial and/or W via2) overlapping with the same conductive pattern, by setting that the quantity of the plurality of auxiliary electrodes overlapping with the first rectangle J1 (extending along the first direction) is greater than or equal to the quantity of the plurality of auxiliary electrodes overlapping with the second rectangle J2, which may be beneficial for reduce the resistance (i.e., the direction of current transmission) of the first cathode ring 7 (or the first cathode ring 102) along the first direction (such as OF1 direction) in the conduction path with the pixel circuit 106, and improve the conductivity, where the direction of current transmission is a direction from the pixel circuit 106 towards the first cathode ring 7 (or the first cathode ring 102).

In at least one display panel provided by the embodiment of the present disclosure, with reference to FIG. 3, FIG. 14, FIG. 15, FIG. 16, and FIG. 17, for the conductive patterns in the second cathode ring 102, orthographic projections of the first connecting electrode W vial and the second connecting electrode W via2, that overlap with the same conductive pattern respectively, on the conductive pattern do not completely overlap.

Among them, orthographic projections of the first connecting electrode W vial and the second connecting electrode W via2, that overlap with the same conductive pattern respectively, on the conductive pattern do not completely overlap, including the following situations:
Firstly, the orthographic projections of the first connecting electrode W vial and the second connecting electrode W via2, that overlap with the same conductive pattern respectively, on the conductive pattern partially overlap.
Secondly, the orthographic projections of the first connecting electrode W vial and the second connecting electrode W via2, that overlap with the same conductive pattern respectively, on the conductive pattern are completely non-overlapping.

In FIG. 14, FIG. 15, FIG. 16, and FIG. 17, it provides Schematic diagram of four types of arrangements of first connecting electrodes W via 1 and second connecting electrodes W via 2 on the conductive pattern of the second cathode ring 102. In FIG. 14 to FIG. 17, corresponding to the same conductive pattern in the second cathode ring 102, the plurality of first connecting electrodes W vial are symmetrically distributed, and the plurality of second connecting electrodes W via2 are also symmetrically distributed. Symmetric distributions include central symmetry and axial symmetry.

In the embodiment of the present disclosure, by setting that the orthographic projections of the first connecting electrode W vial and the second connecting electrode W via2, that overlap with the same conductive pattern respectively, on the conductive pattern do not completely overlap, the first connecting electrode W vial and the second connecting electrode W via2 are dispersed as much as possible on the same conductive pattern in the second cathode ring 102, which is beneficial for the conductivity stability of the first connecting electrode W vial and the second connecting electrode W via2 with the same conductive pattern in the second cathode ring 102, thereby improving the quality and reliability of the display panel.

In addition, it should be noted that as shown in FIG. 2, the light emitting devices Q located in the active area AA can emit light and display, while the light emitting devices Q located in the partial area (Dummy area) of the peripheral area BB cannot emit light or display. Among them, the light emitting devices Q located in the partial area (Dummy area) of the peripheral area BB is used to improve the structural consistency between the active area AA and the peripheral area BB of the display panel, to avoid visible color differences at the boundary area of the active area AA and the peripheral area BB of the display panel in the dark state due to significant structural differences, and enable a natural transition between the active area AA and the peripheral area BB, thereby improving the aesthetics of the display panel.

In the specification, there is no restriction on the plane figure of active area AA in the above display panel. For example, the plane figure of active area AA can be a rectangle as shown in the accompanying drawings of the embodiments of the present disclosure. Alternatively, the plane figure of active area AA can also be other polygons, such as pentagons, hexagons, etc., depending on the usage scenario and requirements. For example, the plane figure of the peripheral area BB can be circular, and the plane figure of the peripheral area BB varies depending on the plane figure of the active area AA. The plane figure of the peripheral area BB can be determined based on the plane figure of the active area AA. The above plane figure refers to the figure of the orthographic projection of the display panel on the substrate.

In some embodiments, the emission color of each light emitting device Q in the active area AA of the display panel is the same, for example, the emission color of each light emitting device Q is blue; or the emission color of each light emitting device Q is white. When the emission color of each light emitting device Q is blue, the color conversion layer may include a first color conversion pattern, a second color conversion pattern, and a third color pattern. Among them, the blue light emitted by the light emitting device Q can be converted into red light after passing through the first color conversion pattern, the blue light emitted by the light emitting device Q can be converted into green light after passing through the second color conversion pattern, and blue light can be emitted after the blue light emitted by the light emitting device Q passing through the third color pattern. Among them, the first color conversion pattern can be a red quantum dot pattern, the second color conversion pattern can be a green quantum dot pattern, and the third color pattern can be a transparent pattern.

In some embodiments, the light emitting devices Q in the active area AA of the display panel include a first color light-emitting device, a second color light-emitting device, and a third color light-emitting device. The first color light-emitting device, the second color light-emitting device, and the third color light-emitting device are arranged in an array according to a certain pattern, where the light emitted by the first color light-emitting device is red light, the light emitted by the second color light-emitting device is green light, and the light emitted by the third color light-emitting device is blue light. At this point, the color conversion layer may include a first filter pattern, a second filter pattern, and a third filter pattern. The first filter pattern may be a red color-resistance pattern, the second filter pattern may be a green color-resistance pattern, and the third filter pattern may be a blue color-resistance pattern. This color conversion layer can also be referred to as a color film layer or a color filter layer (as indicated by CF in FIG. 2 and FIG. 3), where the orthographic projection of the first filter pattern on the substrate 1 overlaps with the orthographic projection of the first color light-emitting device on the substrate 1, the orthographic projection of the second filter pattern on the substrate 1 overlaps with the orthographic projection of the second color light-emitting device on the substrate 1, and the orthographic projection of the third filter pattern on the substrate 1 overlaps with the orthographic projection of the third color light-emitting device on the substrate 1.

As shown in FIG. 2 or FIG. 3, the above-mentioned lens layer 2 includes a plurality of lens structures 21 or 22, the lens layer 2 is located at least on the side of each light emitting device Q away from the substrate 1, that is to say, the lens layer 2 is located at least on the light emitting side of each light emitting device Q, to adjust the optical path of the display light emitted by the light emitting device Q and improve the luminous efficiency.

The material of the lens layer 2 may include one of silicon nitride, silicon oxide, and silicon oxynitride. In addition, the refractive index of the material of the lens layer 2 is greater than the refractive index of the material of the film layer located on the light emitting side of the lens layer 2 and in direct contact with the lens layer 2.

In some embodiments, as shown in FIG. 2, the outer contour of the orthographic projection of the lens layer 2 on the substrate 1 overlaps with the inner contour of the orthographic projection of the first cathode ring 7 on the substrate 1.

For example, as shown in FIG. 2, the lens layer 2 includes a plurality of first lenses 22 and a plurality of second lenses 21. Each first lens 22 is located in the active area AA, and each second lens 21 is located in the peripheral area BB. The height of each second lens 21 along a direction perpendicular to the plane where the substrate 1 is located is less than or equal to the height of each first lens 22 along the direction perpendicular to the plane where the substrate 1 is located.

For example, as shown in FIG. 2, along the direction pointing from the active area AA to the peripheral area BB, the height of each second lens 21 gradually decreases along the direction perpendicular to the plane where the substrate 1 is located.

In the display panel provided by the embodiments of the present disclosure, by setting the height of the first lens 22 located in the active area AA to be greater than or equal to the height of the second lens 21 located in the peripheral area BB, the first lens 22 can converge the display light emitted from the active area AA, and improve the luminous efficiency, at the same time, the second lens 21 can also serve as a transitional structure. On the one hand, the second lens 21 close to the junction of the active area AA and the peripheral area BB can converge light to a certain extent, thus avoiding uneven brightness in the partial area of the active area AA close to the peripheral area BB. On the other hand, it can further improve the structural consistency between the active area AA and the peripheral area BB of the display panel, thus avoiding visible color differences in the boundary area between the active area AA and the peripheral area BB of the display panel in the dark state due to significant structural differences. Which enables a natural transition between the active area AA and the peripheral area BB, thereby further enhancing the aesthetic appeal of the display panel.

In some embodiments, as shown in FIG. 3, there is a gap or connection between the outer contour of the orthographic projection of the lens layer 2 on the substrate 1 and the inner contour of the orthographic projection of the first cathode ring 7 on the substrate 1.

In some embodiments, as shown in FIG. 2 or FIG. 3, the display panel further includes a light shielding layer ZG, which is located in the peripheral area BB and surrounds the active area AA, and the light shielding layer ZG and the color filter layer CF are arranged in the same layer.

It should be noted that, the light shielding layer ZG and the color filter layer CF being arranged in the same layer refers to the light shielding layer ZG and the color filter layer CF being formed in the same patterning process, and does not mean that the thicknesses of the light shielding layer ZG and the color filter layer CF are the same.

Among them, the color filter layer CF includes a black matrix BM, a red filter pattern R, a green filter pattern G, and a blue filter pattern B.

In some embodiments, the light shielding layer ZG may include a single-layer structure, for example, the light shielding layer ZG is prepared using the same material as the black matrix BM.

In other embodiments, the light shielding layer ZG may include a multi-layer structure, and for example, the light shielding layer ZG may include multiple sub-layers. For example, the light shielding layer ZG may include: a first sub-layer made of the same material as the red filter pattern, a second sub-layer made of the same material as the green filter pattern, and a third sub-layered layer made of the same material as the blue filter pattern. Among them, the arrangement order of the first sub-layer, the second sub-layer, and the third sub-layer is not limited here. For example, the first sub-layer, the second sub-layer, and the third sub-layer can be arranged in sequence along the direction away from the substrate. For example, the first sub-layer, the third sub-layer, and the second sub-layer can be arranged in sequence along the direction away from the substrate. For example, the second sub-layer, the first sub-layer, and the third sub-layer can be arranged in sequence along the direction away from the substrate. Certainly, other situations can also be included, which can be determined according to the preparation process sequence of the red filter pattern, the green filter pattern, and the blue filter pattern.

In some embodiments, as shown in FIG. 2 or FIG. 3, the orthographic projection of the first cathode ring 7 on the substrate 1 is located within the orthographic projection of the light shielding layer ZG on the substrate 1.

In the exemplary embodiment, the light shielding layer ZG located in the peripheral area BB surrounds the active area AA, and it can be understood that the shape of the projection of the light shielding layer ZG can be circular. The specific shape of the above-mentioned ring is not limited here. For example, the ring can include a circular ring, an elliptical ring, a polygonal ring, etc.

In the embodiments of the present disclosure, by setting the light shielding layer ZG, in this way, the light shielding layer ZG can block at least part of the circuits and wirings in the peripheral area BB, thus avoiding reducing the display effect due to the reflection of light.

Among them, the orthographic projection of the first cathode ring 7 on the substrate 1 is located within the orthographic projection of the light shielding layer ZG on the substrate 1, including but not limited to the following situations:
Firstly, an outer contour of the orthographic projection of the first cathode ring 7 on the substrate 1 is located within an outer contour of the orthographic projection of the light shielding layer ZG on the substrate 1.
Secondly, the outer contour of the orthographic projection of the first cathode ring 7 on the substrate 1 overlaps with the outer contour of the orthographic projection of the light shielding layer ZG on the substrate 1.

In the embodiments of the present disclosure, by setting that the orthographic projection of the first cathode ring 7 on the substrate 1 is located within the orthographic projection of the light shielding layer ZG on the substrate 1, the light shielding layer ZG can block the first cathode ring 7, thus avoiding reducing the display effect due to the reflection of light generated on the first cathode ring 7.

In the exemplary embodiment, as shown in FIG. 2, the display panel further includes a first encapsulation layer TFE1 and a second encapsulation layer TFE2, both of which may include an organic layer and an inorganic layer. The material of the inorganic layer may be a combination of one or more of silicon nitride, silicon oxide, silicon oxynitride, or aluminum oxide, and the material of the organic layer may be polyimide or poly (p-xylene).

In the exemplary embodiment, as shown in FIG. 3, the display panel further includes an encapsulation layer TFE, which includes multiple sub-layers arranged in stacked. For example, the encapsulation layer TFE includes a silicon oxynitride sub-layer, a silicon nitride sub-layer, a silicon oxynitride sub-layer, and a silicon nitride sub-layer arranged in sequence along the direction away from the substrate 1.

In the exemplary embodiment, as shown in FIG. 3, the display panel further includes at least one barrier dam (Dam) located in the peripheral area BB, which is a closed annular structure used to prevent water vapor at the edge of the display panel from infiltrating into the display panel along the extension path of the material of the pixel definition layer PDL. It can be understood that the barrier dam (Dam) is a groove dug on the pixel definition layer PDL.

In the exemplary embodiment, as shown in FIG. 1B and FIG. 3, the display panel further includes a binding terminal 5 located in the peripheral area BB, the binding terminal 5 is provided with an opening 105 for exposing a portion of the conductive material of the binding terminal 5, so that the binding terminal 5 may be electrically connected to the circuit board FPC (the circuit board FPC is not shown in FIG. 3). Among them, the electrical connection mode between the binding terminal 5 and the driving unit is not shown in the accompanying drawings of this specification. For details, please refer to the introduction in related art.

In addition, with reference to FIG. 2, FIG. 3, FIG. 18 and FIG. 19, the display panel also includes an adhesive layer 11 and a cover plate 12 (CG). As shown in FIG. 13, the display panel may also include an aluminum oxide layer 21 and a silicon nitride layer 22, which are used to improve the luminous efficiency of the light emitting device. The display panel may also include a first flat layer 23, a second flat layer 24, a third flat layer 25, and a protective portion 103.

The protective part 103 is arranged around the second cathode ring 102, that is, the protective part 103 is a closed ring. In addition, the protective part 103 extends from the bottommost metal layer of the driving baseplate 100 (the metal layer closest to the substrate 1) to the topmost metal layer of the driving baseplate 100 (the metal layer farthest from the substrate 1), and the metal layers in the protective part 103 can be electrically connected through tungsten holes. The protective part 103 is also covered with insulating material. Among them, the protective part 103 is used to protect the edges of the driving baseplate, and during the preparation or use of the display panel, it may prevent cracks on the edges of the driving baseplate 100 from extending into the interior of the display panel, thereby improving the quality and reliability of the display panel.

Certainly, the above display panel may also include other structures and components. This specification only introduces the structures and components related to the invention, and other structures and components included in the display panel can refer to the introduction in related art.

The embodiments of the present disclosure provide a display device including a display panel as described above.

The structure of the display panel can refer to the description as described above, and will not be repeated here.

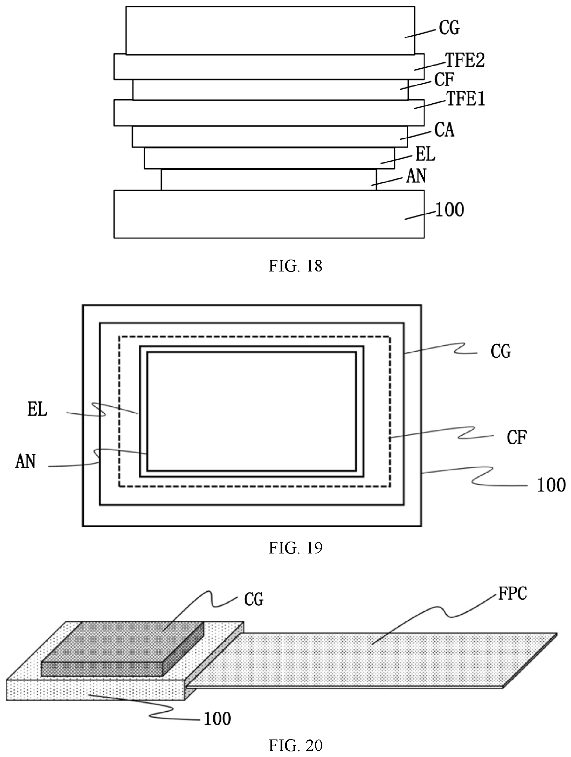

As shown in FIG. 20, the display device also includes a flexible circuit board FPC and a driver chip IC;
alternatively, the display panel may include a display control unit, and the display device may also include a flexible circuit board FPC.

The display device provided in the embodiments of the present disclosure may be an OLED display device, wherein the OLED display device may include a glass-based OLED display device and a silicon-based OLED display device.

In addition, the display device can be a display device such as OLED display, as well as any product or component with display function including televisions, digital cameras, mobile phones, tablets, etc.

In the exemplary embodiment, when the substrate 1 of the display panel is a silicon substrate, the array baseplate of the silicon substrate in the display device can integrate a pixel driving circuit array, a source driver, a gate driver, an emission control driver, an oscillator (OSC), a gamma register, and display control unit integrated circuit on the same chip. At this point, there is no need to set up additional driving chips, and the display panel can be directly electrically connected to the flexible circuit board FPC, which is called One Chip technology. The integration of display devices prepared by One Chip technology is higher, but the size is smaller and can be applied to high-resolution display products, such as in the field of near eye displays of virtual reality or augmented reality.

In the exemplary embodiment, when the substrate of the display panel is a silicon substrate, the array baseplate of the silicon substrate can also separate the analog circuit parts such as the pixel driving circuit array, the source driver, the gate driver, the emission driver (EOA unit) from OSC, the gamma register, the Interface, and the display control unit, changing from One Chip technology to Two Chip technology. At this point, the display panel needs to be electrically connected to the flexible circuit board FPC and the driver chip IC, respectively. Compared to products with One Chip technology, the manufacturing process requirements for such products are low, and low process technology can be used to reduce production costs.

The display device can be a flexible display device (also known as a flexible screen) or a rigid display device (i.e., a display device that cannot be bent), without limitation here. The display device can be an OLED display device, or any product or component with display function including OLED TVs, digital cameras, mobile phones, tablets, etc. This display device has the advantages of good display effect, long lifespan, and high stability.

The above is only a specific implementation of the present disclosure, but the scope of protection of the present disclosure is not limited to this. Any person skilled in the art can easily think of changes or replacements within the technical scope disclosed in the present disclosure, which should be included in the scope of protection of the present disclosure. Therefore, the scope of protection of the present disclosure should be based on the scope of protection of the claims.

## Claims

1. A display panel, comprising an active area and a peripheral area, the peripheral area surrounding the active area; **characterized in that** the display panel further comprises:
a substrate and a plurality of light emitting devices arranged in an array on the substrate, the plurality of light emitting devices being located at least in the active area;
a first conductive layer, comprising a first cathode ring and anodes of the plurality of light emitting devices, wherein the first cathode ring is located in the peripheral area and the first cathode ring surrounds the active area, and the first cathode ring is electrically connected to a pixel circuit of the display panel;
wherein the first cathode ring comprises a plurality of conductive patterns, a gap is provided between two adjacent conductive patterns, and a plane figure of each of the conductive patterns comprises a concave polygon.

2. The display panel according to claim 1, **characterized in that** a shape of an orthographic projection of each of the conductive patterns on the substrate comprises a figure formed by splicing a first extension part and a second extension part together; and
the first extension part extends along a first direction, the second extension part extends along a second direction, the first direction is a direction pointing from the active area to the peripheral area, and the second direction is perpendicular to the first direction.

3. The display panel according to claim 2, **characterized in that** a plane figure of the first extension part is a first rectangle, and a plane figure of the second extension part is a second rectangle; and
a geometric center of the first rectangle overlaps with a geometric center of the second rectangle, a first side of the first rectangle is perpendicular to a first side of the second rectangle, and the first side is a long side of a rectangle.

4. The display panel according to claim 3, **characterized in that** the plurality of conductive patterns comprise a first conductive pattern group and a second conductive pattern group that are alternately arranged along the first direction, and the first conductive pattern group and the second conductive pattern group are both arranged around the active area;
the first conductive pattern group comprises a plurality of first conductive patterns arranged along the second direction, and the second conductive pattern group comprises a plurality of second conductive pattern arranged along the second direction; and
a shape of a line connecting geometric centers of two first conductive patterns adjacent along the first direction and a geometric center of a second conductive pattern between the two first conductive patterns adjacent along the first direction is a first triangle.

5. The display panel according to claim 4, **characterized in that** structures and sizes of the first conductive patterns are the same as that of the second conductive patterns.

6. The display panel according to claim 5, **characterized in that** at least one side length of the first triangle is 3~5 times a maximum size of sub-pixels in the active area.

7. The display panel according to claim 5, **characterized in that** the first triangle is an isosceles triangle.

8. The display panel according to claim 7, **characterized in that** the first side of the first rectangle extends along the first direction, the first side of the second rectangle extends along the second direction, and an area of the first rectangle is greater than an area of the second rectangle.

9. The display panel according to claim 8, **characterized in that** along the first direction, a minimum distance between the second conductive pattern and the first conductive pattern that is on a side close to the active area is a first distance, a minimum distance between the second conductive pattern and the first conductive pattern that is on a side away from the active area is a second distance, and the first distance and the second distance are roughly equal.

10. The display panel according to claim 9, **characterized in that** along the second direction, a minimum distance between the second conductive pattern and the first conductive pattern on one side of the second conductive pattern is a third distance, a minimum distance between the second conductive pattern and the first conductive pattern on another side of the second conductive pattern is a fourth distance, and the third distance and the fourth distance are roughly equal.

11. The display panel according to claim 10, **characterized in that** ranges of the first distance, the second distance, the third distance and the fourth distance are all 0.5~2 times a maximum size of sub-pixels in the active area.

12. The display panel according to claim 11, **characterized in that** the first distance, the second distance, the third distance and the fourth distance are all roughly equal.

13. The display panel according to claim 9, **characterized in that** a length of the first side of the first rectangle is less than or equal to a length of the first side of the second rectangle, and the length of the first side of the second rectangle is greater than 0.5 times the length of the first side of the first rectangle.

14. The display panel according to claim 2, **characterized in that** a maximum width of the first extension part along the second direction is greater than a maximum width of the second extension part along the first direction.

15. The display panel according to claim 13, **characterized in that** in the first rectangle and the second rectangle, the length of the first side is greater than a length of a second side; and
an absolute value of a difference between the length of the first side of the first rectangle and the length of the second side of the first rectangle is greater than or equal to 0.5~2 times a maximum size of sub-pixels in the active area.

16. The display panel according to claim 8, **characterized in that** for the first conductive pattern and the second conductive pattern adjacent along the first direction, a minimum distance from the first side of the second rectangle in the first conductive pattern to the first side of the second rectangle in the second conductive pattern is a fifth distance; a minimum distance from the first side of the second rectangle in the second conductive pattern to the first side of the second rectangle in the first conductive pattern is the fifth distance; in the same conductive pattern, and a minimum distance between the first side of the first rectangle and the second side of the second rectangle is a sixth distance; the fifth distance is greater than the sixth distance.

17. The display panel according to claim 8, **characterized in that** for two first conductive patterns adjacent along the first direction, a minimum distance between the first sides of the second rectangles in the two first conductive patterns is a seventh distance; for two second conductive patterns adjacent along the first direction, a minimum distance between the first sides of the second rectangles in the two second conductive patterns is the seventh distance;
for two first conductive patterns adjacent along the second direction, a minimum distance between the first sides of the first rectangles in the two first conductive patterns is an eighth distance; for two second conductive patterns adjacent along the second direction, a minimum distance between the first sides of the first rectangles in the two second conductive patterns is the eighth distance;
wherein the seventh distance is greater than or equal to the eighth distance.

18. The display panel according to claim 17, **characterized in that** a ratio of a length of the seventh distance to a length of the first side of the first rectangle, is greater than or equal to a ratio of a length of the eighth distance to a length of a second side of the first rectangle.

19. The display panel according to claim 8, **characterized in that** a first hollow area is provided between two conductive patterns adjacent along the second direction;
a line connecting geometric centers of two first hollow areas adjacent along the first direction and a geometric center of a conductive pattern between the two first hollow areas adjacent along the first direction is a first line segment; and
a line connecting the geometric centers of the two first conductive patterns adjacent along the first direction is a second line segment; the first line segment is parallel to the second line segment.

20. The display panel according to claim 19, **characterized in that** a length of the first line segment and a length of the second line segment are roughly equal.

21. The display panel according to claim 19, **characterized in that** two first hollow areas arranged along the first direction and located on two sides of the first rectangle, and two first hollow areas arranged along the second direction and located on two sides of the second rectangle are disposed around the same conductive pattern; and
a shape formed by a line connecting geometric centers of four first hollow areas around the same conductive pattern in sequence is a quadrilateral, the quadrilateral comprises two second triangles, and the two second triangles are the same as the first triangle.

22. The display panel according to any one of claims 4 to 21, **characterized in that** the display panel further comprises a plurality of auxiliary electrodes, the plurality of auxiliary electrodes are disposed in the peripheral area, two adjacent auxiliary electrodes arranged along the first direction are not in contact with each other, the orthographic projections of the plurality of conductive patterns on the substrate overlap with orthographic projections of the plurality of auxiliary electrodes on the substrate, and the plurality of conductive patterns are electrically connected to the plurality of auxiliary electrodes.

23. The display panel according to claim 22, **characterized in that** the plane figures of the plurality of conductive patterns are axisymmetric shapes, the plurality of conductive patterns have first axes of symmetry extending along the second direction; areas where the first axes of symmetry are located overlap with areas where the orthographic projections of the plurality of auxiliary electrodes on the substrate are located.

24. The display panel according to claim 22, **characterized in that** the display panel further comprises a pixel definition layer and a cathode layer located on one side of the pixel definition layer away from the substrate, a part of the pixel definition layer located in the peripheral area comprises a plurality of first through-holes; the first cathode ring is disposed at bottoms of the plurality of first through-holes; and
a part area of the cathode layer falls into the plurality of first through-holes and is electrically connected to the plurality of conductive patterns through the plurality of first through-holes.

25. The display panel according to claim 24, **characterized in that** the display panel further comprises a driving baseplate, the driving baseplate comprises the substrate and a driving unit, and the driving unit is located between the substrate and the first conductive layer; and
a part of the driving unit located in the peripheral area comprises a second cathode ring, a part of the driving unit located in the active area comprises a pixel circuit, the second cathode ring is electrically connected to the first cathode ring and the pixel circuit, respectively; an orthographic projection of the second cathode ring on the substrate is located within an orthographic projection of the first cathode ring on the substrate.

26. The display panel according to claim 25, **characterized in that** a width of the second cathode ring along the first direction is less than a width of the first cathode ring along the first direction, and structures of the conductive patterns in the second cathode ring are the same as that of the conductive patterns in the first cathode ring.

27. The display panel according to claim 25, **characterized in that** the plurality of auxiliary electrodes comprises a plurality of first connecting electrodes and a plurality of second connecting electrodes, the driving baseplate comprises a second conductive layer, and the second conductive layer is located between the plurality of second connecting electrodes and the substrate; and
the plurality of first connecting electrodes are located between the first cathode ring and the second cathode ring, and the plurality of first connecting electrodes contact and are electrically connected to the first cathode ring and the second cathode ring, respectively; the plurality of second connecting electrodes are located between the second conductive layer and the second cathode ring, the plurality of second connecting electrodes contact and are electrically connected to the second cathode ring and the second conductive layer, respectively, and the second conductive layer is electrically connected to the pixel circuit.

28. The display panel according to claim 27, **characterized in that** for the plurality of auxiliary electrodes overlapping with the same conductive pattern in the first cathode ring, a quantity of a plurality of auxiliary electrodes overlapping with the first rectangle is greater than or equal to a quantity of a plurality of auxiliary electrodes overlapping with the second rectangle.

29. The display panel according to claim 27, **characterized in that** for the conductive patterns in the second cathode ring, orthographic projections of the first connecting electrode and the second connecting electrode, that overlap with the same conductive pattern respectively, on the conductive pattern do not completely overlap.

30. A display device, **characterized in that** the display device comprises the display panel according to any one of claims 1 to 29.
